# EUROPÄISCHE PATENTSCHRIFT

(11) **EP 1 329 816 B1**
(45) Veröffentlichungstag und Bekanntmachung des Hinweises auf die Patenterteilung: **22.06.2011**
(21) Anmeldenummer: 03008161.6
(22) Anmeldetag: 22.12.1997
(51) Int. Cl.: H03K 19/177, G06F 17/50, G06F 15/80

(54) **Verfahren zum selbständigen dynamischen Umladen von Datenflussprozessoren (DFPs) sowie Bausteinen mit zwei- oder mehrdimensionalen programmierbaren Zellstrukturen (FPGAs, DPGAs, o.dgl.)**
Method for automatic dynamic unloading of data flow processors (dfp) as well as modules with bidimensional or multidimensional programmable cell structures (fpgas, dpgas or the like)
Procédé pour le transfert dynamique automatique de processeurs à flux de données (dfp) ainsi que de modules à deux ou plusieurs structures cellulaires programmables bidimensionnelles ou multidimensionnelles (fpga, dpga ou analogues)

(30) Priorität: 27.12.1996 DE 19654846
(43) Veröffentlichungstag der Anmeldung: 23.07.2003
(62) Teilanmeldung aus: 97954332.9
(73) Patentinhaber: Richter, Thomas, 04703 Bockelwitz (DE); Krass, Maren, 8044 Zürich (CH)
(72) Erfinder: Vorbach, Martin, 80689 München (DE); Münch, Robert, D-76185 Karlsruhe (DE)
(74) Vertreter: Pietruk, Claus Peter

(56) Entgegenhaltungen:
- EP-A- 0 678 985
- EP-A- 0 748 051
- SALEEBA M: "A self-contained dynamically reconfigurable processor architecture" SIXTEENTH AUSTRALIAN COMPUTER SCIENCE CONFERENCE. ACSC-16, BRISBANE, QLD., AUSTRALIA,, Bd. 15, Nr. 1, pt.A, 3. Februar 1993 (1993-02-03), - 5. Februar 1993 (1993-02-05) Seiten 59-70, XP002064400 ISSN 0157-3055, AUSTRALIAN COMPUTER SCIENCE COMMUNICATIONS, 1993, AUSTRALIA

## Beschreibung

### Hintergrund der Erfindung

### Stand der Technik

Die sich heutzutage im Einsatz befindenden programmierbaren Bausteine (DFPs, FPGAs (Field Programmable Gate Arrays)) können auf zwei verschiedene Arten programmiert werden:
1. Einmalig, das heißt die Konfiguration kann nach der Programmierung nicht mehr geändert werden. Alle konfigurierten Elemente des Bausteins führen also die gleiche Funktion, über den gesamten Zeitraum in dem die Anwendung abläuft, durch.
2. Im Betrieb, das heißt die Konfiguration kann nach Einbau des Bausteins, durch das Laden einer Konfigurationsdatei, zum Startbeginn der Anwendung, geändert werden. Die meisten Bausteine (insbesondere die FPGA Bausteine), lassen sich während des Betriebes nicht weiter umkonfigurieren. Bei umkonfigurierbaren Bausteinen ist eine Weiterverarbeitung von Daten während des Umkonfigurierens meistens nicht möglich und die benötigte Zeit erheblich zu groß.

Die programmierbaren Bausteine werden durch ein Hardware-Interface mit ihren Konfigurationsdaten geladen. Dieser Vorgang ist langsam und benötigt meistens mehrere hundert Millisekunden auf Grund der beschränkten Bandbreite zum externen Speicher, in dem die Konfigurationsdaten abgelegt sind. Danach steht der programmierbare Baustein in der gewünschten/programmierten Funktion, wie in der Konfigurationsdatei beschrieben, zur Verfügung.
Eine Konfiguration entsteht dadurch, daß ein spezielles Bitmuster beliebiger Länge, in die konfigurierbaren Elemente des Bausteines eingetragen wird. Konfigurierbare Elemente können zum Beispiel alle Arten von RAM Zellen, Multiplexer, Vernetzungselemente oder ALUs sein. Ein Konfigurationswort wird in in einem solchen Element gespeichert, so daß das Element seine durch das Konfigurationswort eingestellte Konfiguration über den Zeitraum des Betriebes beibehält.

### Probleme

Die existierenden Verfahren und Möglichkeiten besitzen eine Reihe von Problemen. Dies sind:
Soll eine Konfiguration in eines DFP (vgl. DE 44 16 881 Al) oder einem FPGA geändert werden, so ist es immer notwendig, daß eine komplette Konfigurationsdatei in den zu programmierenden Baustein übertragen wird, auch wenn nur sehr kleine Teile der Konfiguration geändert werden sollen.
Während dem Laden einer neuen Konfiguration kann der Baustein keine, oder nur eingeschränkt, Daten weiterverarbeiten. Durch die immer größer werdende Anzahl an konfigurierbaren Elementen pro Baustein (insbesondere bei den FPGA Bausteinen), werden die Konfigurationsdateien dieser Bausteine ebenfalls immer größer (mittlerweilen einige hundert Kilobyte an Daten). Einen großen Baustein zu konfigurieren dauert daher sehr lange und macht eine Umkonfigurierung während der Laufzeit oft unmöglich oder beeinträchtigt die Arbeitsweise des Bausteins.
Bei einer Teilkonfigurierung eines Bausteins zur Laufzeit, wird immer eine zentral Logik-Instanz benutzt, über welche alle Umkonfigurierungen verwaltet werden. Dies führt zu einem sehr hohen Kommunikations- und Synchronisations-Aufwand.

Aus der EP 0 748 051 ist ein Konfigurationssystem für eine Logikzelle innerhalb eines programmierbaren Feldes umfasst mit einer Vielzahl von Programmierworten, die simultan im programmierbaren Feld abgelegt werden, wobei jedes programmierbare Wort in Eingriff gebracht werden kann, um eine Konfiguration der Logikzelle zu steuern; und ein Mittel, um ein ausgewähltes Programmierwort der Vielzahl von Programmierwörtern in Eingriff zu bringen, um die Konfiguration der Logikzelle zu steuern.

### Verbesserung durch die Erfindung

Durch die beschriebene Erfindung ist eine Umkonfigurierung eines programmierbaren Bausteines wesentlich schneller möglich. Die Erfindung ermöglicht eine flexible Nutzung von verschiedenen Konfigurationen eines programmierbaren Bausteins zur Laufzeit, ohne dabei die Arbeitsfähigkeit des programmierbaren Bausteines zu beeinträchtigen oder zu stoppen. Veränderungen an der Konfiguration des Bausteins werden gleichzeitig durchgeführt und stehen somit sehr schnell, ohne daß, unter Umständen, weitere Konfigurationsdaten übertragen werden müssen, zur Verfügung. Das Verfahren kann für alle Arten von konfigurierbaren Elementen eines konfigurierbaren Bausteins sowie für alle Arten von Konfigurationsdaten, egal für welchen Zweck diese innerhalb des Bausteins bestimmt sind, eingesetzt werden.

Die Aufgabe der vorliegenden Erfindung besteht darin, programmierbare Bausteine in einer verbesserten Weise für eine dynamische Konfigurierung und Umkonfigurierung auszugestalten.

Die Lösung dieser Aufgabe wird in unabhängiger Form beansprucht. Bevorzugte Ausführungsformen finden sich in den Unteransprüchen.

Durch die Erfindung ist es möglich, die statischen Beschränkungen herkömmlicher Bausteine aufzuheben und eine Verbesserung der Ausnutzung vorhandener konfigurierbarer Elemente zu erreichen. Durch die Einführung eines Zwischenspeichers ist es möglich über die selben Daten eine Vielzahl unterschiedlicher Funktionen auszuführen.
Die Einzelheiten und besondere Ausgestaltungen, sowie Merkmale des erfindungsgemäßen Bussystems sind Gegenstand der Patentansprüche.

### Beschreibung der Erfindung

### Übersicht über die Erfindung, Abstrakt

Auf einem programmierbaren Baustein existiert eine Vielzahl an Ring-Speichern, das sind Speicher mit einer eigenen Adressteuerung, die, wenn sie das Ende des Speichers erreicht hat, an dessen Anfang weiterläuft, wodurcch sich ein Ring ergibt. Dies Ring-Speicher können schreiben und lesend auf, Konfigurationsregister, also die die Konfigurationsdaten entgegennehmenden Schaltkreise, der zu konfigurierenden Elemente zugreifen. Ein solcher Ring-Speicher besitzt eine bestimmte Anzahl an Einträgen, welche durch eine Ladelogik, wie in Offenlegung DE 44 16 881 A1 beschrieben, mit Konfigurationsdaten geladen werden. Der Aufbau der Einträge ist dabei so gewählt, daß ihr Datenformat, dem/den an den Ring-Speicher angeschlossenen konfigurierbaren Elementen entspricht und das Einstellen einer gültigen Konfiguration erlaubt.

Weiterhin existiert ein Lese-Positionszeiger, der einen der Einträge des Ring-Speichers, als aktuellen Lese-Eintrag selektiert. Der Lese-Positionszeiger kann durch eine Steuerung auf beliebige positionen/Einträge innerhalb des Ring-Speichers bewegt werden Weiterhin existiert eine Schreib-Positionszeiger, der einen der Einträge des Ring-Speichers, als aktuellen Schreib-Eintrag selektiert. Der Schreib-Positionszeiger kann durch eine Steuerung auf beliebige Positionen/Eintrage innerhalb des Ring-Speichers bewegt werden.

Zur Laufzeit kann über diesen Ring-Speicher ein Konfigurationswort in das zu konfigurierende Element übertragen werden um eine Umkonfigurierung durchzuführen, ohne daß die Daten durch eine zentrale Logik verwaltet oder übertragen werden müssen. Durch den Einsatz mehrerer Ring-Speicher können viele konfigurierbaren Elemente gleichzeitig umkonfiguriert werden.

Da ein Ring-Speicher mit seiner kompletten Steuerung konfigurierbare Zellen zwischen mehreren Konfigurationsmodi umschalten kann, wird er Switching-Tabelle genannt.

### Detailbeschreibung der Erfindung

Auf einem programmierbaren Baustein oder extern an diesen Baustein angeschlossen, existiert eine Menge an Ring-Speichern. Dem oder den Ring-Speichern zugeordnet sind eine oder mehrere Steuerungen, welche den oder die Ring-Speicher steuern. Diese Steuerungen sind ein Teil der in der offenlegung DE 44 16 881 A1 genannten Ladelogik. Die Ring-Speicher enthalten Konfigurationsworte für die zu konfigurierenden Elemente eines oder einer Vielzahl von konfigurierbaren Bausteinen, dabei können die konfigurierbaren Elemente auch ausdrücklich der Vernetzung von Funktionsgruppen dienen und Crossbar-Schaltungen oder Multiplexer zum Verschalten von Busstrukturen nach dem Stand der Technik sein.

Die Ring-Speicher und'die Steuerung des Ring-Speichers können entweder direkt in Hardware implementiert sein, oder aber erst durch die Konfiguration einer oder einer Mehrzahl von konfigurierbaren Zellen eines konfigurierbaren Bausteins (zum Beispiel FPGA) entstehen.

Als Ring-Speicher können Ring-Speicher nach Stand der Technik zum Einsatz kommen und insbesondere Ring-Speicher und/oder Steuerungen mit folgenden Eigenschaften:
1. In denen nicht die gesamten Einträge genutzt werden, und welche eine Möglichkeit besitzen, eine Position anzugeben, an der der Lese- und/oder Schreib-Positionszeiger des Ring-Speichers an den Anfang oder das Ende des Ring-Speichers gesetzt wird. Dies läßt sich zum Beispiel durch Befehlswörter (STOP, GOTO, etc.), Zähler oder Register, welche die Start- und Stop-Position speichern, implementieren.
2. Welche die Auftrennung des Ring-Speichers in unabhängige Sektionen ermöglichen und die Steuerung des Ring-Speichers derart,. über die zum Beispiel unten aufgeführten Ereignisse, eingestellt werden kann, daß sie auf einer dieser Sektionen arbeitet.
3. Welche die Auftrennung des Ring-Speichers in unabhängige Sektionen ermöglichen und es eine Mehrzahl an Steuerungen gibt, welche jeweils auf einer Sektion arbeiten. Dabei kann eine Mehrzahl an Steuerungen auch auf der gleichen Sektion arbeiten. Dies kann durch eine Arbiter-Schaltung realisiert werden. In diesem Fall gehen einige Verarbeitungszyklen verloren. Weiterhin können Register anstatt RAM zum Einsatz kommen.
4. Jede Steuerung einen oder mehrere Lese-Positionszeiger und/oder einen oder mehrere Schreib-Positionszeiger besitzt.
5. Diese Positionszeiger vorwärts und/oder rückwärts bewegt werden können.
6. Diese Positionszeiger auf Grund eines oder mehrere Ereignisse auf den Beginn, das Ende oder eine angegebene Position gesetzt werden können.
7. Die-Steuerung ein Maskenregister besitzt mit dem, durch Eintragen eines Datenwortes, aus der Menge aller möglichen Ereignisse eine Teilmenge selektiert werden kann. Nur diese Teilmenge an Ergebnissen, wird als Ereignis an die Steuerung weitergeleitet und lößt die Weiterschaltung des/der Positionszeiger aus.
8. Steuerungen, welche mit einem mehrfachen Takt des eigentlichen Systemtakts arbeiten (oversampling) um das Abarbeiten mehrerer Einträge innerhalb eines Systemtakts zu ermöglichen.

Die Steuerung der Switching-Tabelle wird durch eine gewöhnliche Zustandsmaschine implementiert. Neben der einfachen.Steuerung, die ein herkömmlicher Ring-Speicher benötigt, sind Steuerungen mit folgenden Eigenschaften bestens geeignet die Steuerung der in der Erfindung beschriebenen Switching-Tabellen eines programmierbaren Bausteins (insbesondere auch von FPGAs und DPGAs (Dynamically Programmable Gate Arrays, neue Untergruppe der FPGAs)) durchzuführen oder gegebenenfalls zu erweitern:
1. Steuerungen, welche spezielle Befehlswörter erkennen können. Ein Befehlswort unterscheidet sich dadurch, daß es eine Kennzeichnung besitzt, die es der Steuerung ermöglicht, die Daten eines Eintrags des Ring-Speichers als Befehlswort und nicht als Datenwort zu erkennen.
2. Steuerungen, welche spezielle Befehlswörter ausführen können. Insbesondere solche Befehle, welche den Ablauf der Zustandsmaschine ändern und/oder Einträge des Ring-Speichers, durch eine Datenverarbeitungs-Funktion, verändern können.
3. Steuerungen, welche eine Kennung erkennen können, und auf Grund dieser Kennung, weitere Einträge der Ring-Speicher durch den internen schnelleren (oversampling) Takt abarbeiten, solange, bis eine Ende-Kennung erreicht wurde, oder aber der nächste Taktzyklus des den Oversampling-Takt steuernden Taktes erreicht wurde.

Als Befehlswörter für die sinnvolle Steuerung einer Switching-Tabelle, welche eine Steuerung mittels Befehlswörtern benötigt, sind besonders die nun genannten Befehle oder eine Teilmenge der genannten Befehle denkbar. Die Befehlswörter, welche Positionszeiger betreffen, können jeweils auf den oder die Lese-Positionszeiger oder aber auf den oder die Schreib-Positionszeiger angewandt werden. Mögliche Befehlswörter sind:

### 1.) Einen WAIT Befehl.

Der WAIT Befehl veranlaßt die Steuerung solange zu Warten bis das nächste Ereignis oder die nächsten (auch verschiedenen) Ereignisse eingetroffen sind. Während dieses Zustandes, werden der oder die Lese-/Schreib-Positionszeiger nicht weiterbewegt. Trifft das Ereignis oder die Ereignisse ein, so wird der oder die Lese-/Schreib-Positionszeiger auf den nächsten Eintrag positioniert.

### 2. Einen SKIP Befehl.

Der SKIP Befehl überspringt eine angegebene Anzahl an Einträgen des Ring-Speichers, in einem von zwei Verfahren:
a. Der SKIP1 Befehl wird komplett in einem Verarbeitungszyklus durchgeführt. Wurde zum Beispiel SKIP 5 angegeben, so wird in einem Verarbeitungszyklüs auf den, vom aktuellen Lese-/Schreib-Eintrag aus, fünf Einträge weiter vorne (hinten) liegenden Eintrag, gesprungen.
b. Der SKIP2 Befehl wird erst nach einer Anzahl an Verarbeitungszyklen durchgeführt. Denkbar ist hier zum Beispiel, daß der Befehl SKIP 5 erst nach fünf Verarbeitungszyklen durchgeführt wird. Dabei wird wieder vom aktuellen Eintrag aus, fünf Einträge nach vorne gesprungen. Der Parameter (in diesem Beispiel die 5) wird bei diesem Verfahren also zweimal genutzt.

Die Angabe der Sprungrichtung kann durch den Einsatz einer vorzeichenbehafteten Zahl sowohl in einer Vorwärtsbwegung, wie auch in einer Rückwärtsbewegung, des oder der Positionszeiger enden.

### 3. Einen SWAP Befehl.

Der SWAP Befehl tauscht die Daten zweier angegebener Einträge gegeneinander aus.

### 4. Einen RESET Befehl.

Der RESET Befehl setzt, den oder die Lese-/Schreib-Positionszeiger auf den Beginn und/oder eine angegebene Eintragsposition, innerhalb des Ring-Speichers.

### 5. Einen WAIT-GOTO Befehl.

Der WAIT-GOTO Befehl, wartet wie der weiter oben beschriebene WAIT Befehl, auf ein oder mehrere bestimmte Ereignisse und führt dann, eine Positionierung des Lese-/Schreib-Positionszeigers auf einen definierten Anfangszustand, innerhalb eines oder mehrere Verarbeitungszyklen, durch.

### 6. Einen NOP Befehl.

Der NOP Befehl führt keine Aktion aus. Es werden weder Daten aus dem Ring-Speicher an das oder die zu konfigurierenden Elemente übertragen, noch werden die Positionszeiger verändert. Der NOP Befehl kennzeichnet somit einen Eintrag als nicht relevant, dieser Eintrag wird aber von der Steuerung des Ring-Speichers angesprochen und ausgewertet, er benötigt als einen oder mehrere Verarbeitungszyklen.

### 7. Einen GOTO Befehl.

Der GOTO Befehl positioniert den oder die Lese-/Schreib-Positionszeiger auf die angegebene Eintragsposition.

### 8. Einen MASK Befehl.

Der MASK Befehl schreibt ein neues Datenwort in den Multiplexer, welcher die verschiedenen Ereignisse auswählt. Mit Hilfe dieses . Befehls ist es also möglich, die Ereignisse, auf welche die Steuerung reagiert, zu ändern.

### 9. Einen LLBACK Befehl.

Der LLBACK Befehl erzeugt eine Rückmeldung an die Ladelogik (im Sinne von Offenlegung DE 44 16 881 A1). Durch diesen.Befehl kann die Switching-Tabelle das Umladen grrößerer Bereiche des Baustein veranlassen, ins besondere jedoch ihr eigenes Umladen.

### 10. Einen Befehl, welcher einen Read/Modify/Write Zyklus auslöst.

Der Befehl löst das Lesen von Befehlen oder Daten in einem anderen Eintrag, zum Beispiel durch die Steuerung, die Ladelogik oder ein außerhalb der Switching-Tabelle liegendes Element, aus. Diese Daten werden dann auf beliebige Art verarbeitet und wieder an die gleiche oder eine andere Position, in den Ring-Speicher der Switching-Tabelle, geschrieben. Dies kann in der Zeitspanne eines Verarbeitungszykluses der Switching-Tabelle geschehen. Der Vorgang ist dann vor dem nächsten Neupositionieren eines Positionszeigers beendet.

Der Aufbau der Einträge des Ring-Speicher hat folgendes Format:

| | | |
|---|---|---|
| Daten/Befehl | Run/Stop | Daten |

Das erste Bit kennzeichnet einen Eintrag als Befehl oder als Datenwort. Die Steuerung der Switching-Table entscheidet damit, ob die Bitkette im Datenteildes Eintrages als Befehl oder als Konfigurationsdaten behandelt werden.

Das zweite Bit kennzeichnet, ob die Steuerung sofort, auch ohne daß ein weiteres Ereignis eingetroffen ist, mit dem nächsten Eintrag fortfahren soll, oder ob auf das nächste Ereignis gewartet werden soll. Wird ein Oversampling-Verfahren eingesetzt, und ist das RUN-Bit gesetzt, so werden die nächsten Einträge mit Hilfe dieses Oversampling-Taktes abgearbeitet. Dies geschieht solange, bis ein Eintrag ohne gesetztes RUN-Bit erreicht wurde, oder die Anzahl der Einträge, welche in der Oversampling-Taktrate innerhalb eines Systemtakt abgearbeitet werden können, erreicht wurde.

Kommt kein Oversamling-Verfahren zum Einsatz, so wird durch den normalen Systemtakt und gesetztes RUN-Bit eine Weiterschaltung veranlaßt. Während des Ablaufes einer, mit dem RUN-Bit gekennzeichneten Befehlsfolge eintreffende Ereignisse werden ausgewertet und das Trigger-Signal in einem Flip-Flop gespeichert.

Die Steuerung wertet dieses Flip-Flop dann wieder aus, wenn ein Eintrag ohne gesetztes RUN-Bit erreicht wurde.

Der Rest eines Eintrags enthält je nach Art (Daten oder Befehl) alle notwendigen Informationen, so daß die Steuerung ihre Aufgabe vollständig durchführen kann.

Die Größe des Ring-Speichers ist der Anwendung entsprechend implementierbar, insbesondere gilt dies für programmierbare Bausteine, bei denen der Ring-Speicher durch die Konfiguration einer oder mehrerer konfigurierbarer Zellen entsteht.

Ein Ring-Speicher ist dabei derart an ein zu konfigurierendes Element --- oder an eine Gruppe von zu konfigurierenden Elementen--- angeschlossen, daß ein selektiertes Konfigurationswort (im Ring-Speicher) in das Konfigurationsregister des zu konfigurierenden Elements oder der Gruppe der zu konfigurierenden Elemente, eingetragen wird.

Dadurch ensteht eine gültige und arbeitsfähige Konfiguration des zu konfigurierenden Elements oder der zu konfigurierenden Gruppe.

Jeder Ring-Speicher besitzt eine Steuerung oder mehrere Steuerungen, welche die Positionierung des Lese-Positionszeiger und/oder des Schreib-Positionszeigers steuert.

Die Steuerung kann, mittels des ind er Offenlegung DE 44 16 881 A1 genannten Rückmeldekanals, auf Ereignisse von anderen Elementen des Bausteins oder durch externe Ereignisse, welche in den Baustein, übertragen werden (zum Beispiel Interrupt, IO-Protokolle etc.) reagieren und bewegt, als Reaktion auf diese internen oder externen Ergeignisse, den Lese-Positionszeiger und/oder den Schreib-Positionszeiger, auf einen anderen Eintrag.

Als Ereignisse sind zum Beispiel denkbar:
1. Taktzyklus einer Rechenanlage.
2. internes oder externes Interrupt-Signal.
3. Trigger-Signal von anderen Elementen innerhalb des Bausteines.
4. Vergleich eines Datenstroms und/oder eines Befehlstroms mit einem Wert.
5. Input/Output Ereigenisse.
6. Ablaufen, überlaufen, neusetzen etc. eines Zählers.
7. Auswerten eines Vergleichs.

Befinden sich mehrere Ring-Speicher auf dem Baustein, so kann die .Steuerung eines jeden Ring-Speichers auf unterschiedliche Ereignisse reagieren.

Nach jeder Bewegung des Lese-Positionszeigers auf einen neuen Eintrag, wird das in diesem Eintrag enthaltene Konfigurationswort an das konfigurierbare Element oder die konfigurierbaren Elemente, welche an den Ring-Speicher angeschlossen sind, übertragen.

Diese Übertragung geschieht in der Art, daß die Arbeitsweise der nicht von der Umkonfigurierung betroffenen Teile des Bausteines, nicht beeinträchtigt wird.

Der oder die Ring-Speicher können sich entweder in einem Baustein befinden, oder aber über ein externes Interface, von außen an den Baustein angeschlossen werden.

Dabei sind auch mehrere unabhängige Ring-Speicher pro Baustein denkbar, welche in einer Region des Bausteins zusammengefaßt sein können oder aber in einer sinnvollen Weise verteilt über die Fläche des Bausteines angeordnet sind.

Die Konfigurationsdaten werden durch eine Ladelogik, wie aus Offenlegung DE 44 16 881 A1 gekannt, oder durch andere interne Zellen des Bausteins in den Speicher der Switching-Tabelle geladen. Die Konfigurationsdaten können durch die Ladelogik oder durch andere interne Zellen des Bausteins dabei auch gleichzeitig an mehrere verschiedene Switching-Tabellen übertragen werden, um ein gleichzeitiges Laden der Switching-Tabellen zu ermöglichen.

Dabei können sich die Konfigurationsdaten auch im Hauptspeicher einer Datenverarbeitungsanlage befinden und anstatt der Ladelogik durch bekannte Verfahren, wie DMA oder prozessorgesteuerte Datentransfers übertragen werden.

Nach dem Laden des Ring-Speichers der Switching-Tabelle durch die Ladelogik, wird die Steuerung der Switching-Tabelle, in einen Startzustand gesetzt, die eine gültige Konfiguration des kompletten Bausteines oder Teilen des Bausteines,, einstellt. Die Steuerung der Switching-Tabelle beginnt nun mit der Neupositionierung des Lese-Positionszeigers und/oder des Schreib-Positionszeigers, als Reaktion auf eintreffende Ereignisse.

Um das Laden neuer Daten in eine Switching-Tabelle oder einer Menge von Switching-Tabellen zu veranlassen kann die Steuerung ein Signal an die Ladelogik, im Sinne von Offenlegung DE 44 16 881 A1, oder andere interne Teile des Bausteins, Welche für das Laden neuer Daten in den Ring-Speicher der Switching-Tabelle verantwortlich sind, zurückgeben. Das Auslösen einer solchen Rückmeldung kann durch die Auswertung eines speziellen Befehls, eine Zählerstandes oder aber von außen (wie in der Patentanmeldung DE 196 51 075.9 in der State-Back-UNIT beschrieben) erfolgen.

Die Ladelogik oder andere interne Zellen des Bausteins werten dieses Signal aus, reagieren auf das Signal durch eine möglicherweise veränderte Programmaüsführung, und Überträgen neue oder andere Konfigurationsdaten an den oder die Ring-Speicher.

Dabei müssen nun nur noch die Daten jener Ring-Speicher übertragen werden, die auf Grund der Auswertung des Signals an einer Datenübertragung beteiligt sind und nicht mehr die Konfigurationsdaten eines kompletten Bausteines.

### Zwischenspeicher

An einzelne konfigurierbare Elemente oder Gruppen derer (nachfolgend Funktionselemente genannt) kann ein Speicher angeschlossen werden. Zur Ausgestaltung dieses Speichers können mehrere Verfahren nach dem Stand der Technik eingesetzt werden, ins besondere bieten sich FIFOs an. Die von den Funktionselementen generierten Daten werden in den Speicher gespeichert, so lange, bis ein Datenpaket mit der gleichen durchzuführenden Operation abgearbeitet ist, oder der Speicher voll ist. Danach werden die Konfigurationselemente über Switching-Tabellen umkonfiguriert, d.h. die Funktion der Elemente ändert sich. Als Triggersignal für die Switching-Tabellen kann dabei das FullFlag dienen, das anzeigt, daß der Speicher voll ist. Um die Datenmenge beliebig bestimmen zu können, ist die Position des FullFlags konfigurierbar, d.h. der Speicher kann ebenfalls durch die Switching-Tabelle konfiguriert werden. Die Daten im Speicher werden auf den Eingang der Konfigurationselemente geführt und eine neue Operation über die Daten wird durchgeführt; die Daten stellen die operanden für die neue Berechnung dar. Dabei können ausschließlich die Daten aus dem' Speicher verarbeitet werden, oder weitere Daten gelangen von außen (von außehalb des Bausteines oder anderen Funktionselementen) hinzu. Beim Abarbeiten der Daten können diese (die Ergebnisse der Operation) an nachfolgende Konfigurationselemente weitergeleitet werden, oder nochmals in den Speicher geschrieben werden. Um sowohl den schreibenden als auch den lesenden Zugriff auf den Speicher zu ermöglichen, kann der Speicher aus zwei Speicherbanken bestehen, die alternierend abgearbeitet werden oder es existiert ein getrennter Lese- und
Schreibpositionszeiger auf demselben Speicher.

Eine besondere Ausgestaltungsmöglichkeit ist der Anschluß mehrerer wie oben beschriebener Speicher. Damit können mehrere Ergebnisse in getrennten Speichern abgelegt werden und zu einem bestimmten Zeitpunkt, zum Ausführen einer bestimmten Funktion, werden mehrere Speicherbereiche gleichzeitig zum Eingang eines Funktionselementes geführt und verrechnet.

### Aufbau eines Eintrages des Ring-Speichers

Ein möglicher Aufbau der Einträge in den Ring-Speichern einer Switching-Tabelle, welche in einer Datenverarbeitungs-Anlage zum Einsatz kommt, wie sie in Offenlegung DE 44 16 881 A1 beschrieben ist, wird nun beschrieben. In den folgenden Tabellen ist der Befehlsaufbau anhand der einzelnen Bits eines Befehlswortes beschrieben:

| Bit-Nummer | Name | Bedeutung |
|---|---|---|
| 0 | Daten/Befehl | Kennzeichnet einen Eintrag als Daten-oder Befehlswort |
| 1 | run/stop | Kennzeichnet run- oder Stop-Mode |

Handelt es sich bei dem Eintrag um einen Dateneintrag, hat das Bit Nuramer 0 also den Wert 0, so haben die Bits ab der Position zwei folgende Bedeutung:

| Bit-Nummer | Name | Bedeutung |
|---|---|---|
| 2..6 | Zellen-Nummer | Gibt die Nummer der Zelle innerhalb einer Gruppe an, welche zusammen eine Switching-Tabelle verwenden |
| 7..11 | Konfigurationsdaten | Gibt die Funktion an, welche die Zelle (zum Beispiel eine EALU) ausführen soll |

Handelt es sich bei dem Eintrag um einen Befehl, das Bit Nummer 0 hat also den Wert 1, so haben die Bits ab der Position zwei folgende Bedeutung:

| Bit-Nummer | Name | Bedeutung |
|---|---|---|
| 2..6 | Befehls-Nummer | Gibt die Nummer des Befehls an, welcher durch die Steuerung der Switching-Tabelle ausgeführt wird |
| 7 | Schreib-/Lese-Positionszeiger | Gibt an, ob der Befehl auf den Schreib- oder, den Lese-Positionszeiger des Ring-Speichers angewendet werden soll. Verändert ein Befehl keine Positionszeiger, so ist der Bitzüstand nicht definiert |
| 8..n | Daten | Ja nach Befehl werden ab Bit 8 die für den Befehl benötigten Daten abgespeichert |

In der nachfolgenden Tabelle sind nun die Bits 2..6 und 8..n für jeden hier aufgeführten Befehl dargestellt. Die insgesamte Bitbreite eines Datenwortes hängt von dem verwendeten Baustein ab, in dem die Switching-Tabelle zum'Einsatz kommt. Die Bitbreite ist so zu wählen, daß alle, für die Befehle benötigten Daten in den Bits ab Position 8 kodiert werden können.

| Befehl | Bit 2..6 | Bit 8..n Bedeutung |
|---|---|---|
| WAIT | 00 00 0 | Anzahl wie oft auf ein Ereignis gewartet werden soll |
| SKIP1 | 00 00 1 | Vorzeichenbehaftete Zahl, die angibt, wieviele Einträge nach vorne(hinten, wenn negativ) gesprungen werden soll |
| SKIP2 | 00 01 0 | Siehe SKIP1 |
| SWAP | 00 01 1 | 1. Eintragsposition, 2. Eintragsposition |
| RESET | 00 10 0 | Nummer des Eintrags auf den der Positionszeiger gesetzt werden soll |
| WAIT- | 00 10 1 | Anzahl wie oft auf ein Ereignis gewartet |
| GOTO | | werden soll, gefolgt von der Nummer des Eintrags auf den der Positionszeiger gesetzt werden soll |
| NOP | 00 11 0 | Keine Funktion! |
| GOTO | 00 11 1 | Nummer des Eintrags auf den der Positionszeiger gesetzt werden soll |
| MASK | 01 00 0 | Bitmuster, welches in den Multiplexer zur Auswahl der Ereignisse eingetragen wird |
| LLBACK | 01 00 1 | Ein Trigger-Signal für die Ladelogik wird generiert (Rückmeldung) |

### Umkonfigurieren von ALUS

Weiterhin ist der Einsatz einer oder mehrerer Switching-Tabellen für die Steuerung einer ALU denkbar. Die beschriebene Erfindung kann zum Beispiel als Verbesserung des Patentes DE 196 51 075.9 benutzt werden, in dem die Switching-Tabelle an die M/F-PLUREG Register angeschlossen wird oder die M/F-PLUREG Register komplett durch eine Switching-Tabelle ersetzt werden.

### Kurzbeschreibung der Diagramme

- Fig.1: zeigt den prinzipiellen Aufbau eines Ringspeichers.
- Fig. 2: stellt den internen Aufbau des Ringspeichers dar.
- Fig. 3: zeigt einen Ringspeicher mit wählbarem Arbeitsbereich.
- Fig. 4: zeigt einen Ringspeicher und eine Steuerung, die über mehrere Schreib- und Lese-Positionszeiger auf verschiedenen Sektionen des Ringspeichers arbeiten kann.
- Fig. 5: stellt einen Ringspeicher dar, auf den verschiedene Steuerungen in unterschiedlichen Sektionen zugreifen.
- Fig. 6.: zeigt einen Ringspeicher und seine Verbindung mit den konfigurierbaren Elementen.
- Fig. 7: zeigt die Steuerung, mit einer Logik um auf verschiedene Triggersignale reagieren zu können, a) Realisierung der Maske für die Triggerimpulse
- Fig. 8: stellt den Taktgenerator für die Steuerung dar.
- Fig. 9: zeigt die Verschaltüng der Steuerung und der internen Zellen, um eine Konfiguration der zu konfigurierenden Elemente zu ermöglichen.
- Fig. 10: stellt die Verarbeitung der im Ringspeicher abgelegten Befehle, durch die Steuerung dar.
- Fig. 11: stellt die Verarbeitung der im Ringspeicher gespeicherten Daten dar.
- Fig. 12: zeigt den Anschluß eines Zwischenspeichers aus zwei Speicherbänken an eine Menge von konfigurierbaren Elementen. Die Figuren a-d zeigen den Ablauf einer Datenverarbeitung.
- Fig. 13: zeigt den Anschluß eines Zwischenspeichers mit getrenntem Schreib-/Lesezeiger an eine Menge von konfigurierbaren Elementen.
- Fig. 14: zeigt die Funktionsweise eines Zwischenspeichers mit getrenntem Schreib-/Lesezeiger.
- Fig. 15: zeigt den Anschluß zweier Zwischenspeicher aus je zwei Speicherbanken an eine Menge von konfigurierbaren Elementen. Die Figuren a-c zeigen den Ablauf einer Datenverarbeitung

### Detailbeschreibung der Diagramme

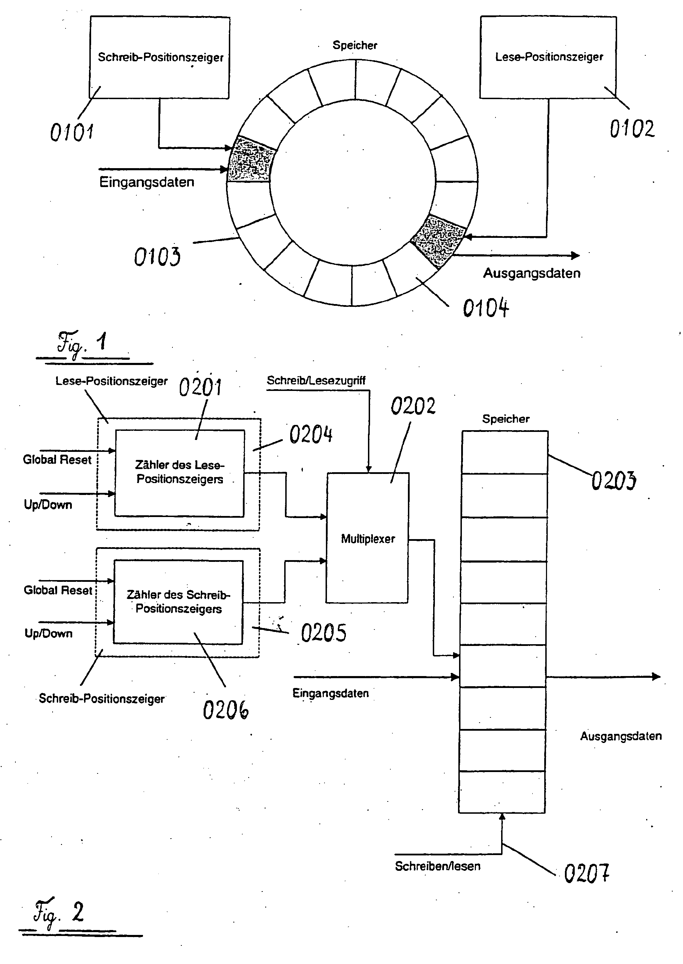

Figur 1 zeigt den prinzipielle Aufbau eines Ringspeichers. Er bestehtaus einem Schreib-Positionszeiger 0101 und einem Lese-Positionszeiger 0102, die auf einen Speicher 0103 zugreifen. Dieser Speicher kann als RAM oder als Register ausgeführt werden. Mit Hilfe der Schreib/Lese-Positionszeiger wird eine Adresse des RAMs 0104 ausgewählt, die abhängig von der gewählten Zugriffsart, mit den Eingangsdaten beschrieben wird, oder deren Daten gelesen werden.

Figur 2 stellt den internen. Aufbau eines einfachen Ringspeichers dar. Für den Schreib/Lese-Positionszeiger steht jeweils ein Zähler zur Verfügung. 0201 stellt den Zähler des Lese-Positionszeigers 0204 dar und 0206 ist der Zähler des Schreib-Positionszeigers 0205. Beide Zähler 0201,0206 besitzten jeweils einen globalen Reset Eingang und einen Up/Down Eingang über den die Zählrichtung festgelegt wird. Über einen Multiplexer 0202, an dessen Eingängen die Ausgänge der Zähler anliegen, wird zwischen Schreib- (0205) und Lese-Positionszeiger (0204), die auf eine Adresse des Speichers 0203 zeigen, umgeschaltet. Der Schreib- und Lesezugriff wird über das Signal 0207 durchgeführt. Bei jedem Schreib- oder Lesezugriff wird der jeweilige Zähler um eine Position weitergezählt. Zeigt nun der Schreib- (0205) oder Lese-Positionszeiger (0204) auf die letzte Position des Speichers (letzte Adresse bei einem aufwärts zählendem Zähler oder die erste Adresse bei einem abwärts zählenden Zähler) so wird der Schreib-oder Lese-Positionszeiger 0205,0204 mit dem nächsten Zugriff auf die erste Position des Speichers 0203 gesetzt (erste Adresse bei einem aufwärts zählenden Zähler oder die letzte Adresse bei einem abwärts zählenden Zähler). Damit ergibt sich die Funktion eines Ringspeichers.

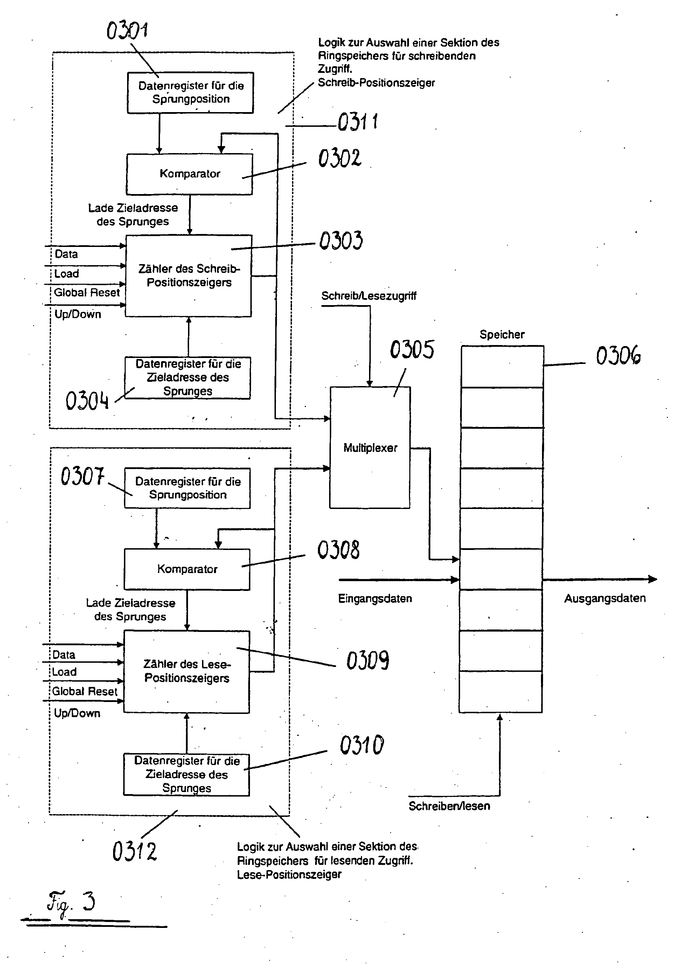

Figur3 stellt eine Erweiterung des normalen Ringspeichers dar. Bei dieser Erweiterung kann der Zähler 0303 des Schreib-Positionszeiger 0311 und der Zähler 0309 des Lese-Positionszeiger 0312 mit einem Wert geladen werden, so daß jede Adresse des Speichers direkt eingestellt werden kann. Dieser Ladevprgang erfolgt wie üblich über die Data- und Load-Eingänge der Zähler. Außerdem kann der Arbeitsbereich des Ringspeichers auf eine bestimmte Sektion des internen Speichers 0306 eingegrenzt werden. Dies erfolgt mit einer internen Logik, welche die Zähler 0303,0309 der Schreib/Lese-Positionzeiger 0311,0312 ansteuert. Diese Logik ist folgendermaßen aufgebaut: Der Ausgang eines Zählers (0303,0309) wird auf den Eingang des zu ihm gehörenden Komparators (0302,0308) geführt. Dort wird der Wert des jeweiligen Zählers mit dem Wert des jeweiligen Datenregisters (0301,0307) in dem die Sprungposition, das heißt das Ende der Sektion des Ringspeichers gespeichert ist, verglichen. Stimmen die beiden Werte überein, so gibt der Komparator (0302,0308) ein Signal an den Zähler (0303, 0309), der dann den Wert aus dem Datenregister für die Zieladresse des Sprunges (0304,0310), das heißt den Beginn der Sektion des Ringspeichers, lädt. Die Datenregister für die Sprungposition (0301, 0307) und die Datenregister für die Zieladresse (0304, 0310) werden von der Ladelogik (vgl. DE 44 16 881) geladen. Mit dieser Erweiterung ist es möglich, daß der Ringspeicher nicht den gesamten Bereich des internen Speichers verwendet/sondern nur einen ausgewählten Teil. Außerdem kann der Speicher, bei der Verwendung mehrerer solcher Schreib/Lese-Positionszeiger (0311,0312) in verschiedene Sektionen aufgeteilt werden.

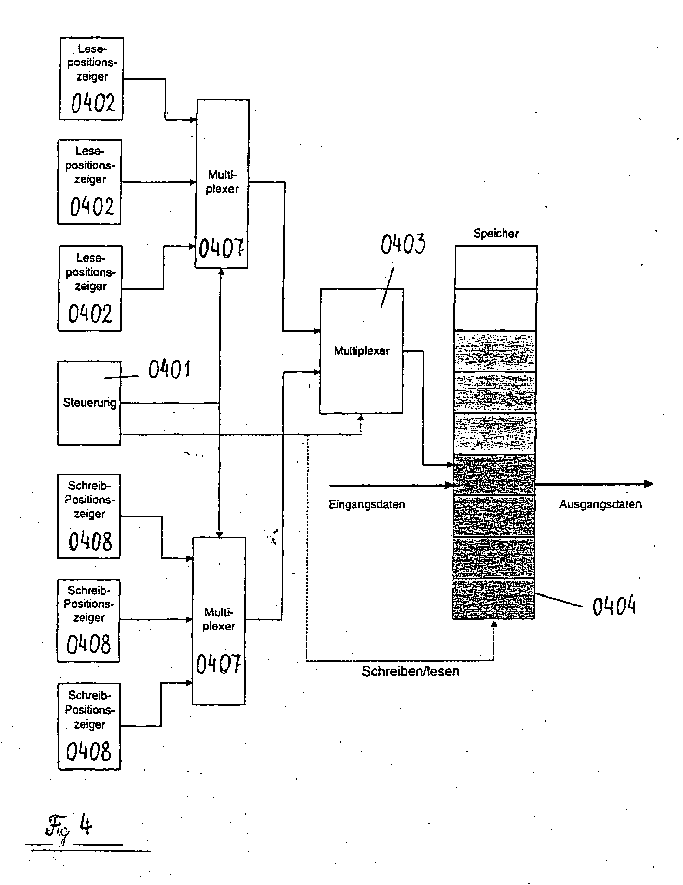

Figur 4 zeigt den Aufbau eines in mehrere Sektionen aufgeteilten Ringspeichers, wobei die Steuerung 0401 auf einer dieser Sektionen arbeitet. Die Steuerung wird detailierter in Figur -7 beschrieben. Um eine Aufteilung des Ringspeichers in mehrere Sektionen zu. ermöglichen, werden mehrere Schreib/Lese-Positionszeiger 0402,0408 verwendet, deren Aufbau in Figur 3 dargestellt wurde. Die Steuerung wählt dabei den Bereich, auf dem sie arbeitet, über die Multiplexer 0407 aus. Der Schreib- oder Lesezugriff wird über den Multiplexer 0403 gewählt. Eine Adresse des Speichers 0404 wird also von dem ausgewählten Schreib/Lese-Positionszeiger adressiert.

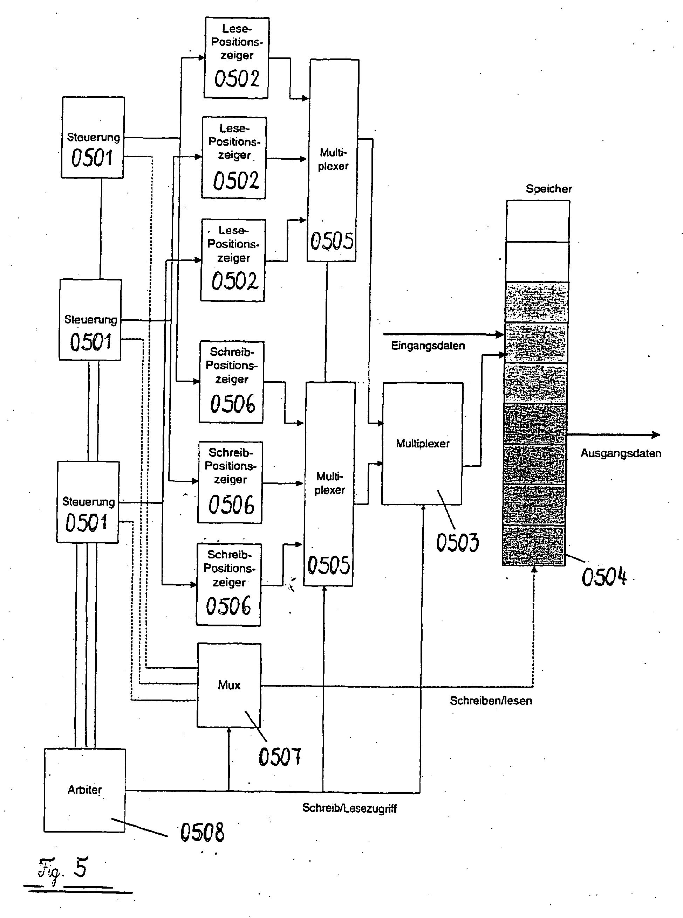

Figur 5 zeigt den Fall, in dem mehrere Steuerungen 0501 über jeweils einen Schreib- und Lese-Positionszeiger 0506,0502 pro Steuerung, auf einem eigenen Bereich des Ringspeichers arbeiten. Jeder Steuerung 0501 ist dabei ein Schreib-Positionszeiger 0506 und ein Lese-Positionszeiger 0502 zugeordnet. Welcher der mehreren Schreib- und Lese-Positionszeiger 0506,0502 auf den Speicher 0504 zugreift, wird über den Multiplexer 0505 ausgewählt. Über den Multiplexer 0503 wird entweder ein Schreib- oder Lesezugriff ausgewählt. Das Schreib/Lesesignal der Steuerungen 0501 gelangt über den Multiplexer 0507 zum Speicher 0504. Das Steuersignal der Multiplexer 0507,0505,0503 verläuft von den Steuerungen 0501 über einen Arbiter 0508 zu den Multiplexern. Durch den Arbiter 0508 wird verhindert, daß mehrere Steuerungen gleichzeitig auf die Multiplexer 0507,0505,0503 zugreifen.

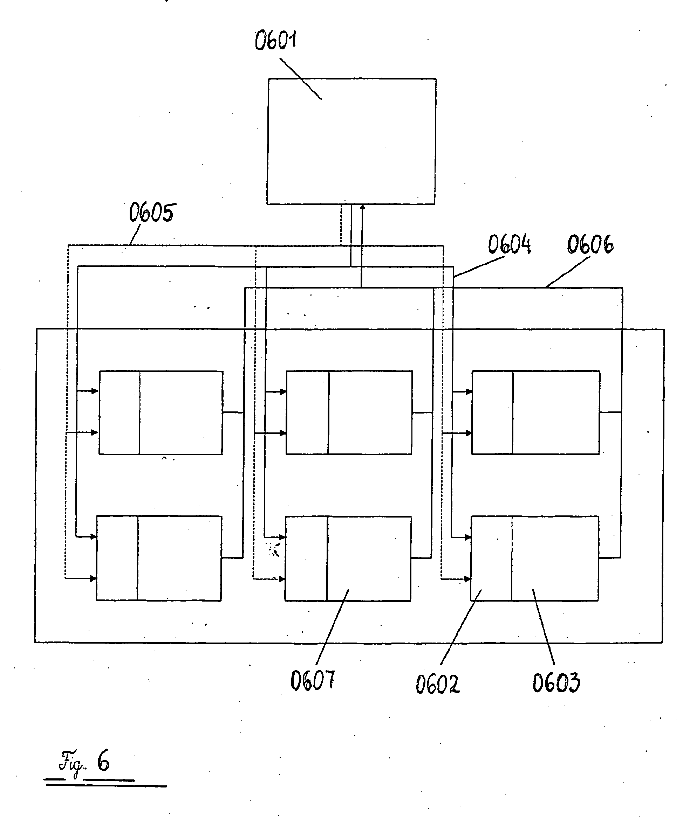

Figur 6 stellt einen Ringspeicher 0601 und seine Verbindung mit den Konfigurationselementen 0602 dar. Der Ringspeicher 0601 ist über 0604, 0605, 0606 verbünden. Über 0604 werden die Adressen der angesprochenen Zellen 0607 übertragen. Die Leitung 0605 überträgt die Konfigurationsdaten aus dem Ringspeicher. Die Zellen 0607 übertragen eine Rückmeldung ob eine Umkonfigurierung möglich ist über die Verbindung 0606. Die im Ringspeicher abgelegten Daten werden in das Konfigurationselement 0602 eingetragen. Dieses Konfigurationselement 0602 bestimmt die Konfiguration der konfigurierbaren Elemente 0603. Die konfigurierbaren Elemente 0603 können z.B. aus logischen Bauteilen, ALUs bestehen.

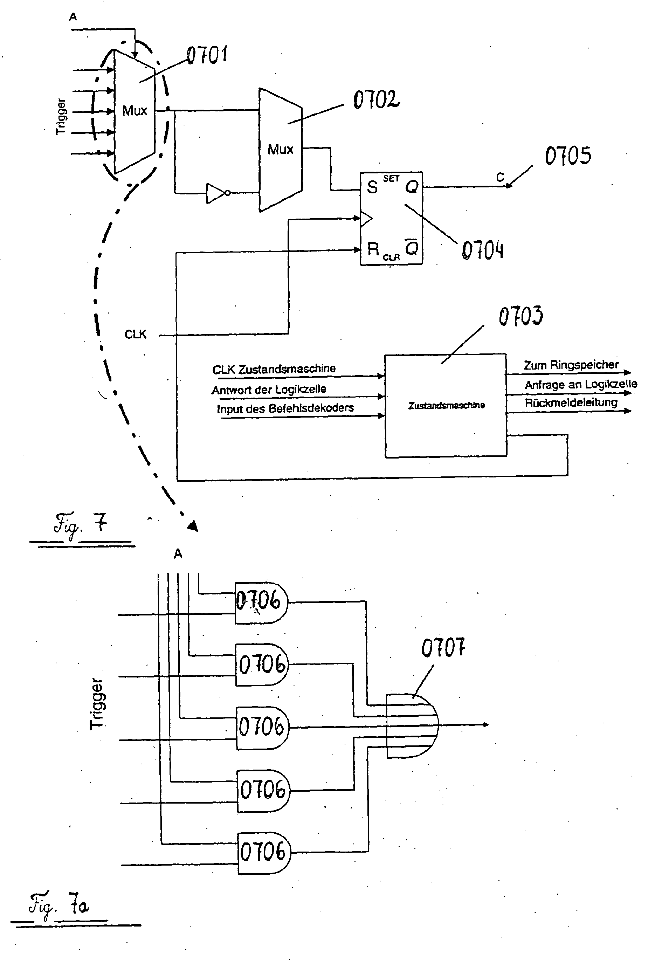

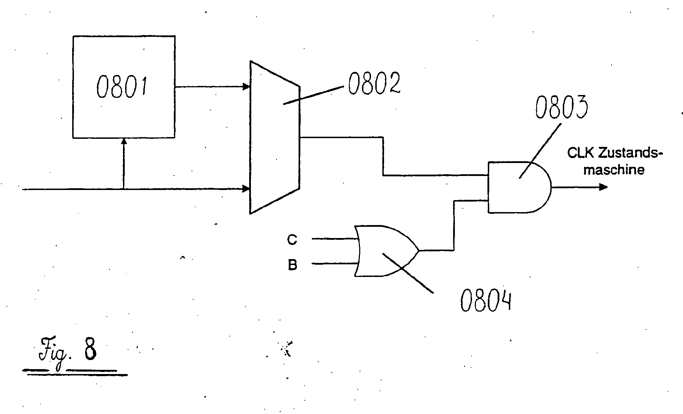

Figur 7 zeigt eine Steuerung die auf verschiedene Triggerereignisse reagieren kann. Die einzelnen Triggerereignisse sind dabei maskierbar, so daß immer nur ein Triggerereignis angenommen wird. Dies erfolgt mit dem Multiplexer 0701. Das Triggersignal wird mit den Flipflop 0704 gespeichert. Der Multiplexer 0702, der auch als Maske über UND-Gatter ausgestaltet sein kann (vgl. Fig. 7a), dient dazu um Low aktive und High aktive Triggersignale verarbeiten zu können. Das im Flipflop gespeicherte Triggersignal wird über 0705 zur Takterzeugung, die in Figur 8 beschrieben ist, weitergegeben. Die Zustandsmaschine 0703 bekommt ihren Takt von der Logik zur Takterzeugung und liefert abhängig von ihren Eingangssignalen ein Ausgangssignal und ein Resetsignal um das Flipflop 0704 zurückzusetzten und die Verarbeitung bis zum nächsten Triggersignales anzuhalten. Vorteil dieser Implementierung ist die Stromersparnis bei Taktabschaltung, da die Zustandsmaschine 0703 dann statisch ist. Eine Implementierung wäre ebenfalls denkbar, in den der Takt immer anliegt und die Zustandsmaschine durch den Zustand des Befehlsdekoders und des run Bit gesteuert wird.

Figur 7a zeigt die Maskierung der Triggersignale. Die Triggersignale und die Leitungen von A liegen auf den Eingängen der UND-Gatter 0706. Die Ausgänge der UND-Gatter 07.06 werden mit 070 verodert und erzeugen das Ausgangssignal.

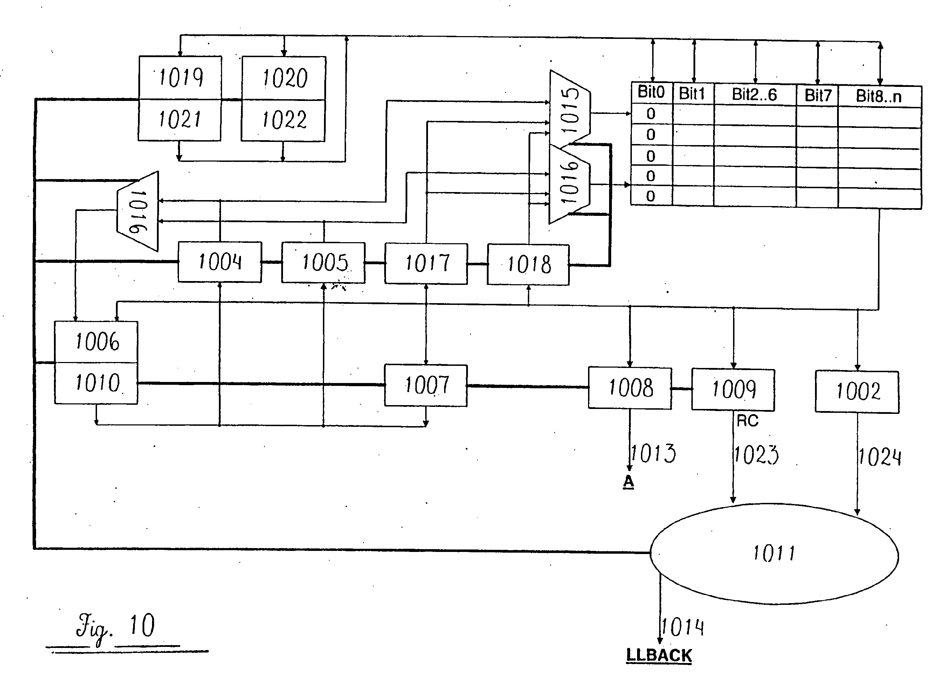

Figur 8 zeigt die Logik zur Takterzeugung für die Zustandsmaschine. In 0801 wird mit Hilfe eines PLL ein anderer Takt erzeugt. über den Multiplexer 0802 kann nun ausgewählt werden, ob der normale Chiptakt oder der Takt des PLL 0801 verwendet wird. Am ODER-Gatter 0804 liegen die Signale C und B an. Das Signal C wird aufgrund eines Triggerereignisses in der Steuerung erzeugt (vgl. Fig 7, 0705). Signal B stammt aus dem Bit 1 des Befehlswortes. (vgl. Fig 10, 1012). Dieses Bit hat die Funktion eines run Flags, sodaß die Steuerung bei gesetztem run Flag unabhängig vom einem Triggerimpuls weiterarbeitet. Der Ausgang des ODER-Gatters 0804 wird mit dem Ausgang des Multiplexers 0802 verundet und erzeugt so den Takt für die Zustandsmaschine.

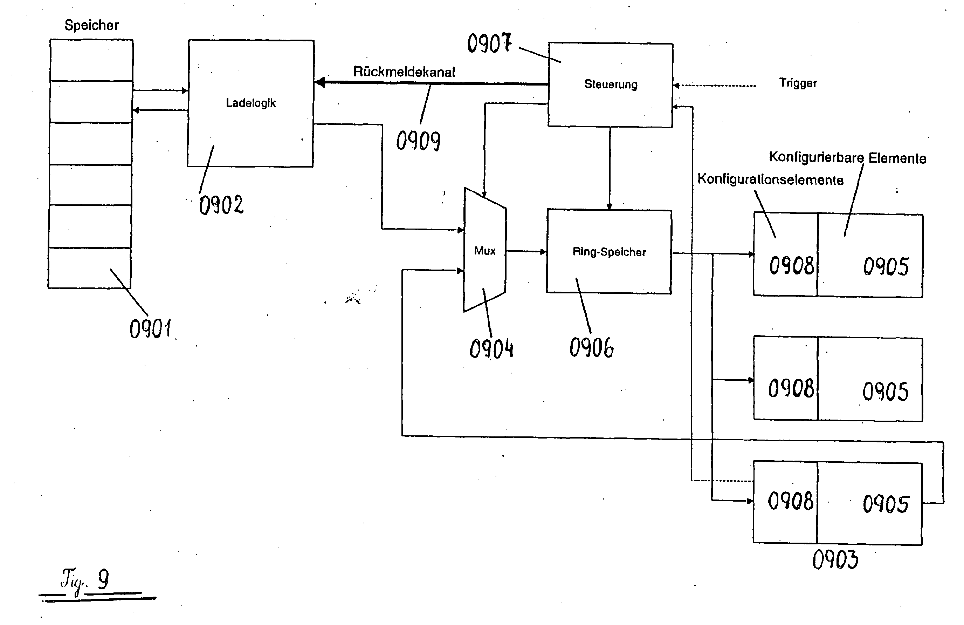

Figur 9 zeigt die Verbindung zwischen der Steuerung 0907, der Ladelogik 0902 mit Speicher 0901, dem Ringspeicher 0906, den konfigurierbaren Elementen 0905 und Konfigurationselementen 0908, sowie den internen zur Konfiguration benutzten Zellen 0903. Hier ist die interne zur Konfiguration verwendete Zelle 0903 als normale Zelle mit konfigurierbaren Elementen 0905 und Konfigurationselemanten 0908 gezeigt. Der Ringspeicher 0906 steht mit den Konfigurationselementen 0908 in Verbindung und wird seinerseits durch die Steuerung 0907gesteuert. Die Steuerung 0907 reagiert auf verschiedene Triggerimpulse, wobei diese Tr-ggerimpulse auch von der internen zur Konfiguration verwendeten Zelle 0903 stammen können. Über den Rückmeldekanal 0909 teilt die Steuerung 0907 der Ladelogik 0902 mit, wenn aufgrund eines Triggerereignisses neue Daten in den Ringspeicher 0906 zu laden sind. Zusätzlich zum Senden dieser Rückmeldung schickt die Steuerung 0907 noch ein Signal an den Multiplexer 0904 und wählt aus, ob Daten aus der Ladelogik 0902 oder der internen zur Konfiguration verwendeten Zelle 0903 zum Ringspeicher geschickt wird.
Außer der Konfiguration des Ring-Speichers durch die Ladelogik, kann der Ring-Speicher wie folgt eingestellt werden: Das konfigurierbare Element 0903 ist so geschaltet, daß es, allein oder als letztes Element einer Gruppe von Elementen Einträge für den Ringspeicher (0906) generiert. Dabei generiert es einen Triggerimpuls, der den Schreibpositionszeiger im Ring-Speicher weiterschaltet. In diesem Modus schaltet der Multiplexer (0904) die Daten von 0903 zum Ring-Speicher durch, während bei einer Konfiguration durch die Ladelogik die Daten von der Ladelogik durchgeschaltet werden. Es wäre selbstverständlich denkbar, daß weitere fest implementierte Funktionseinheiten als Quelle der Konfigurationssignale dienen.

Figur 10 zeigt die Befehlsverarbeitung der in den Ringspeichern abgelegten Befehle durch die Steuerung. 1001 stellt den Speicher des Ringspeichers mit folgender Bitaufteilung dar. Bit 0 kennzeichnet den Eintrag als Daten- oder Befehlswort. Bit 1 kennzeichnt den run- und Stop-Mode. Bit 2..6 bezeichnet, die Befehlsnummer, welche die Befehle kodiert. Bit 7 gibt. an ob der Befehl auf den Lese- oder Schreib-Positionszeiger angewendet werden soll. Beeinflußt der Befehl keinen Positionszeiger, so ist Bit 7 undefiniert. In Bit 8..n werden die für einen Befehl benötigten Daten abgelegt. Die Zähler 1004, 1005 bilden die zum Ringspeicher gehörenden Schreib/Lese-Positionszeiger. Empfängt die Steuerung einen Triggerimpuls, gibt die Zustandsmaschine einen Impuls an den Lese-Positionszeiger. Der Schreib-Positionszeiger wird zum Lesen eines Befehles nicht benötigt, sondern wird nur für den Eintrag von Daten in den Ringspeicher benutzt. Der gewählte Lese-Positionszeiger bewegt sich um eine Position weiter und ein neuer Befehl wird selektiert (Bit 0=0). Am Befehlsdecoder 1002 liegen nun die Bits 2..6 und Bit 7 an, werden dekodiert und das Ergebnis wird zur Zustandsmaschine weitergeleitet (1024). Diese erkennt um welchen Befehl es sich handelt und schaltet entsprechend.
- Handelt es sich um einen Skip Befehl so gibt die Zustandsmaschine 1011 einen Impuls an den Addierer/Subtrahierer 1006 damit er zu den über den Multiplexer 1003 anliegenden Daten aus den Zählern 1004,1005, die Daten des Befehlswortes aus Bit 8..n addiert oder subtrahiert. Der Multiplexer 1003 wählt abhängig von Bit 7 den Zähler des Schreib-Positionszeigers 1004 oder den Zähler des Lese-Positionszeigers 1005. Nachdem die Daten addiert/subtrahiert wurden, aktiviert die Zustandsmaschine 1011 das Tor 1010 und gibt ein Übernahmesignal an den Zähler 1004, 1005. Damit zeigt der ausgewählte Positionszeiger um soviele. Positionen nach vorne oder hinten wie in den Daten des Skip Befehles angegeben.
- Bei einem GOTO Befehl wird von der Zustandsmaschine 1011 das Tor 1007 aktiviert, so daß die Daten abhängig von Bit 7 zum Schreib- oder Lese-Positionszähler 1004,1005 gelangen und dort übernommen werden.
- Beim MASK Befehl werden die Daten in ein-Latch 1008 übernommen und dort gespeichert. Diese Daten stehen dann über die Verbindung A (1013) der in Figur 7/7 a beschriebenen Steuerung bereit und maskieren dort alle Triggereingänge von denen kein Triggerimpuls übernommen werden soll.
- Bei einem WAIT Befehl wird so oft auf ein Ereignis gewartet, wie in den Daten-Bits angegeben. Wird von der Zustandsmaschine 1011 dieser Befehl registriert, so gibt sie einen Impuls an den Wartezyklus-Zähler 1009, der die Daten übernimmt. Der Wartezyklus-Zähler zählt nun bei jedem von der Zustandsmaschine 1011 weitergeleiteten Ereignis eine Stelle nach unten. Sobald er auf null gezählthat wird das Carry Flag gesetzt und zur Zustandsmaschine 1011 geleitet (1023). Durch das Carry Flag läuft die Zustansmaschine danach weiter.
- Bei einem WAIT-Goto Befehl werden die Daten, welche die Anzahl der Wait-Ereignisse angeben in den Wartezyklus-Zähler übernommen. Nach dem Eintreffen der Anzahl der in den Daten angegebenen Ereignissen aktiviert die Zustandsmaschine das Tor 1007 und leitet die Daten für.die Sprungposition in den gewählten Zähler weiter.
- Der SWAP Befehl dient zum Tausch zweier Einträge zwischen zwei Positionen des Ringspeichers. In Latch 1017 wird die Adresse des ersten zu tauschenden Eintrages gespeichert, in Latch 1018 die Adresse des 2. Eintrages. Die. Adressen werden an die Multiplexer 1015 und 1016 der Schreib-/Lesezeiger weitergeleitet. Zunächst wird über 1016 der Eintrag 1 selektiert und in das Latch 1019 gespeichert, danach wird über 1016 der Eintrag 2 selektiert und in 1020 gespeichert. Über 1015 wird der Schreibzeiger auf den 1. Eintrag gesetzt und über Tor 1022 die ehemaligen Daten von Eintrag 2 gespeichert. Danach wird über 1015 wird der Schreibzeiger auf den 2. Eintrag gesetzt und über Tor 1021 die ehemaligen Daten von Eintrag 1 gespeichert.
- Die Zustandsmaschine 1011 sendet über 1014 Rückmeldungen an die Ladelogik (z.B. über eine State-Back-UNIT vgl. DE 196 51 075.9). Über diese Verbindung gibt die Zustandsmaschine ein Signal, sobald ein LLBack Befehl registriert wird.
- Das Bit 1, das als run Flag dient, Wird zur Taktgenerierung der Steuerung geleitet, die in Figur 8 beschrieben wird.
- Der NOP Befehl wird in der Zustandsmaschine registriert, es wird jedoch keine Operation durchgeführt.

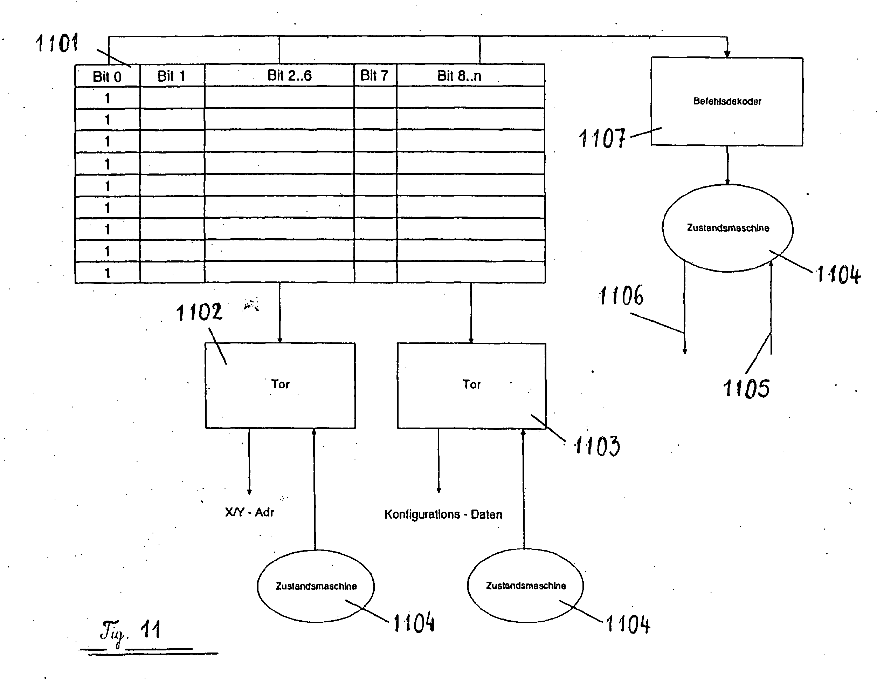

Figur 11 zeigt die Verarbeitung eines im Ringspeicher gespeicherten Datenwortes. 1101 entspricht 1001 der Figur 10. Da es sich um ein Datenwort handelt ist das Bit 0 auf eins gesetzt. Der Befehlsdekoder 1107 erkennt, daß es sich um ein Datenwort handelt und schickt eine Anfrage 1106 an die in den Bits 2..6 adressierte Zelle, ob eine ümkonfigurierung möglich ist. Das Abschicken der Anfrage geschieht gleichzeitig mit dem aktivieren des Tores 1102 wodurch die Adresse der Zelle übertragen wird. Die Zelle zeigt über 1105 ob eine Umkonfigurierung möglich ist. Wenn ja, Tor 1103 um die Konfigurationsdaten an die Zelle zu übertragen. Wenn keine Unkonfigurierung möglich ist läuft die Verarbeitung weiter und im nächsten Umlauf im Ringspeicher wird die Umkonfiguration erneut versucht. Eine andere Möglichkeit des Ablauf sieht folgendermaßen aus. Die Zustandsmaschine aktiviert Tor 1102 und 1103 und überträgt die Daten zur adressierten Zelle. Ist eine Umkonfigurierung der Zelle möglich, quittiert die Zelle über 1105 den Empfang der Daten. Ist keine Umkonfigurierung möglich schickt die Zelle kein Empfangssignal und im nächsten Umlauf des Ringspeichers wird die Umkonfigurierung erneut versucht.

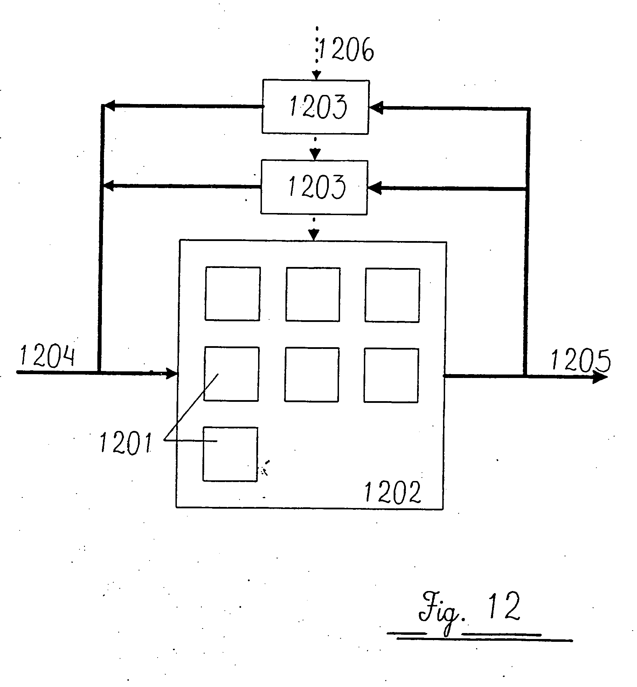

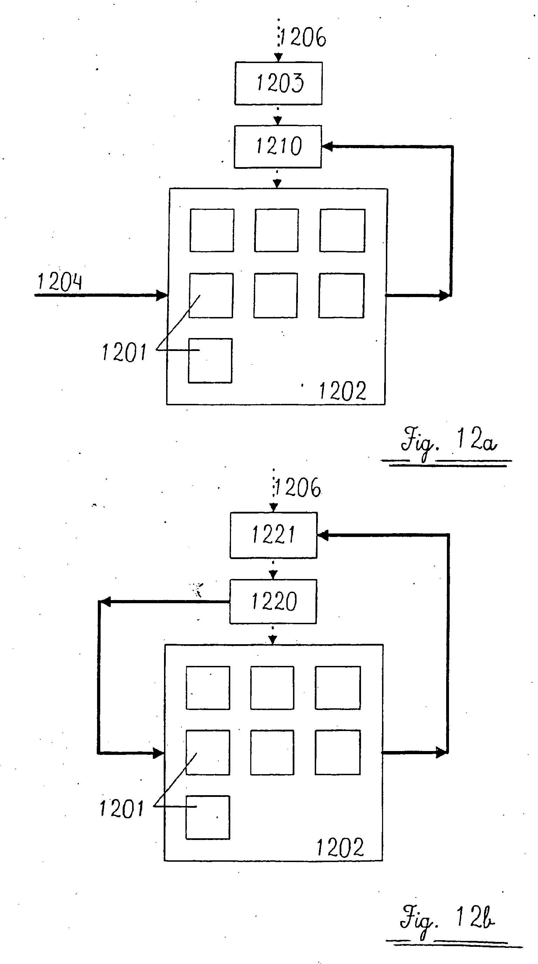

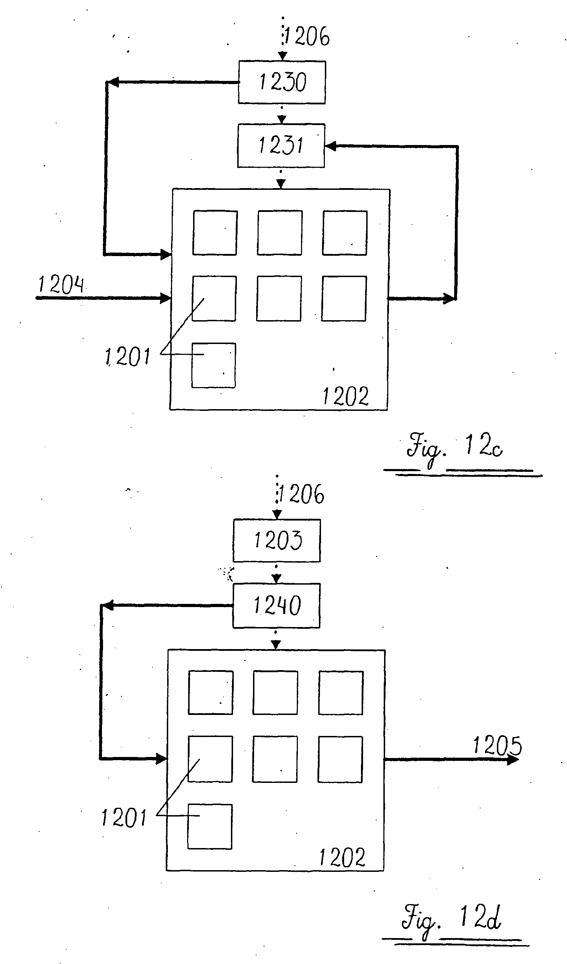

Figur 12 zeigt eine Gruppe (Funktionselement) (1202) von konfigurierbaren Elementen (1201). Die Daten gelangen über den Eingangsbus (1204) in das Funktionselement und die Ergebnisse werden über den Ausgangsbus (1205) weitergeleitet. 1205 wird dabei unter anderem auf zwei Speicherbänke (1203) geleitet, von denen abwechselnd je einer als Schreib- oder Lesespeicher arbeitet. Deren Ausgänge sind auf den Eingangsbus (1204) geschaltet. Die gesamte Schaltung kann über einen Bus zu den Switching-Tabellen (1206) konfiguriert werden, dabei werden sowohl die Triggersignale zur Switching-Tabelle, als auch die Konfigurationsdaten von der Switching-Tabelle über diesen Bus übertragen. Dabei wird neben der Funktion des Funktionselementes der momentan aktive Schreib/Lesespeicher und die Speichertiefe des jeweiligen Speichers eingestellt.

Figur 12a zeigt wie Daten von außen (1204), also einer anderen Funktionseinheit oder außerhalb des Bausteins, in dem Funktionselement (1202) berechnet werden und dann in den Schreibspeicher (1210) geschrieben werden.

Figur 12b zeigt den nächsten Schritt nach Figur 12a. Das Funktionselement (1202) und die Speicher (1220, 1221) wurden nach einem von dem Funktionselement oder den Speichern oder einer anderen Einheit generierten Trigger über 1206 umkonfiguriert. Der Schreibspeicher (1210) ist jetzt als Lesespeicher (1220) konfiguriert und liefert die Daten für das Funktionselement. Die Ergebnisse werden im Schreibspeicher (1221) gespeichert.

Figur 12c zeigt den nächsten Schritt nach Figur 12b. Das Funktionselement (1202) und die Speicher (1230, 1231) wurden nach einem von dem Funktionselement oder den Speichern oder einer anderen Einheit generierten Trigger über 1206 umkonfiguriert. Der Schreibspeicher (1221) ist jetzt als Lesespeicher (1230) konfiguriert und liefert die Daten für das Funktionselement. Die Ergebnisse werden im Schreibspeicher (1231) gespeichert. In diesem Beispiel werden, zusätzliche Operanden von außen (1204), also einer anderen Funktionseinheit oder außerhalb des Bausteins, mit verrechnet.

Figur 12d zeigt den nächsten Schritt nach Figur 12c. Das Funktionselement (1202) und die Speicher (1203, 1240) wurden nach einem von dem Funktionselement oder den Speichern oder einer anderen Einheit generierten Trigger über 1206 umkonfiguriert. Der Schreibspeicher (1231) ist jetzt als Lesespeicher (1240) konfiguriert und liefert die Daten für das Funktionselement. Die Ergebnisse werden über den Ausgabebus (1205) weitergeleitet.

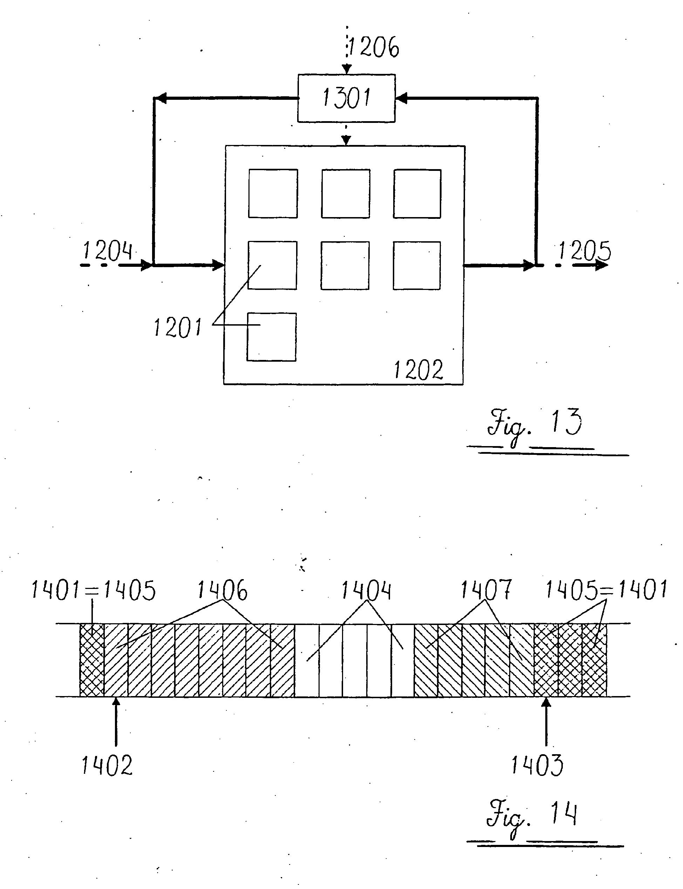

Figur 13 zeigt eine Schaltung nach Figur 12, dabei ist anstatt der beiden Speicherbanke ein Speicher mit getrenntem Schreib- und Lesezeiger eingesetzt (1301).

Figur 14 zeigt den Speicher (1401) nach Figur 13. 1402 ist der Lesepositionszeiger, der Eintrag vor dem Zeigerist bereits gelesen oder frei (1405). Der Zeiger zeigt auf einen freien Eintrag. Hinter dem Lesepositionzeiger liegen Daten (1406), die noch gelesen werden müssen. Danach folgt Freiraum (1404) und bereits neu geschriebene Daten (1407). Der Schreibpositionszeiger (1403) zeigt auf einen freien Eintrag, der entweder leer ist oder schon gelesen wurde. Der Speicher kann als Ring-Speicher, wie bereits beschrieben, ausgestaltet sein.

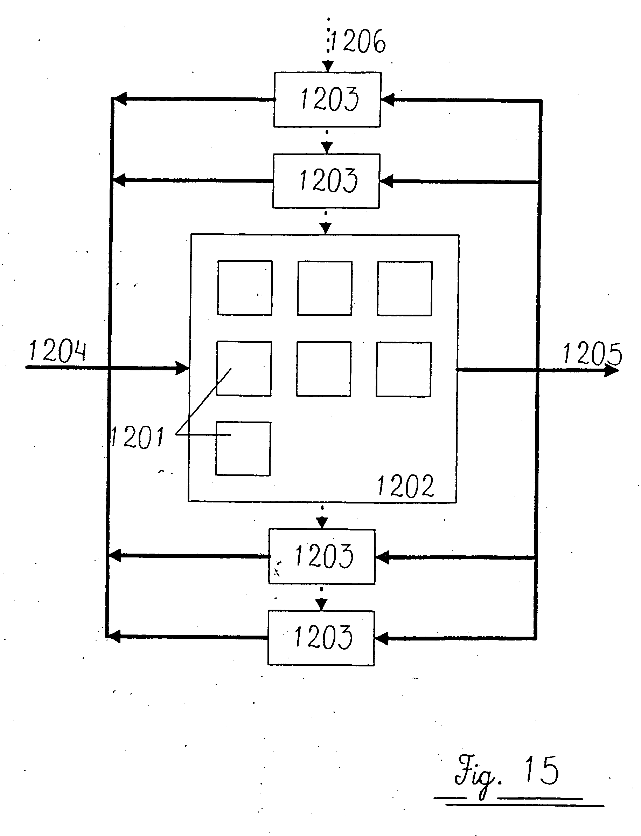

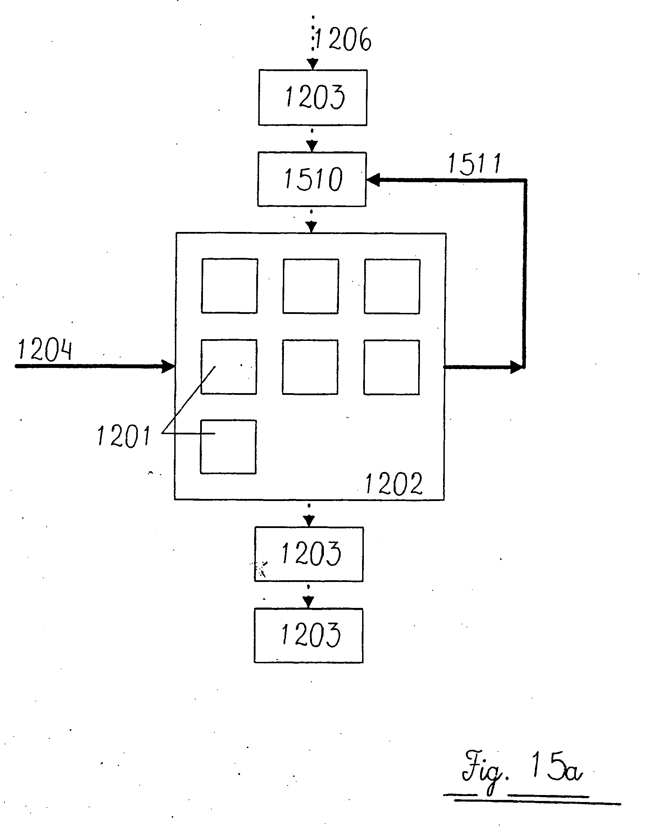

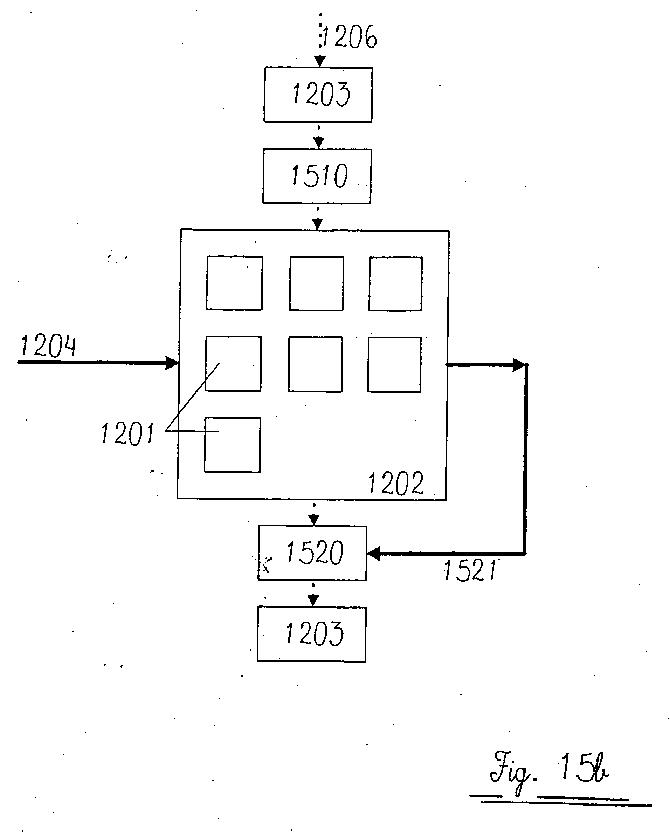

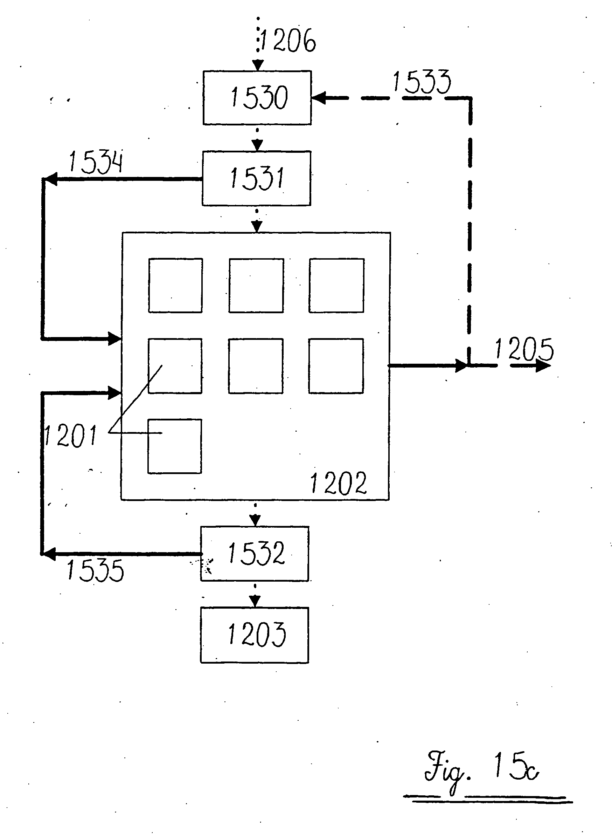

Figur 15 zeigt eine Schaltung nach Figur 12, dabei sind die beiden Speicherbanke (1203) doppelt vorhanden Dadurch können mehrere Ergebnisse gespeichert und danach zusammen verarbeitet werden.

Figur 15a zeigt wie Daten von außen (1204), also einer anderen Funktionseinheit oder außerhalb des Bausteins, in dem Funktionselement (1202) berechnet werden und dann über den Bus 1511 in den Schreibspeicher (1510) geschrieben werden.

Figur 15b zeigt den nächsten Schritt nach Figur 15a. Das Funktionselement (1202) und die Speicher (1203, 1510, 1520) wurden nach einem von dem Funktionselement oder den Speichern oder einer anderen Einheit generierten Trigger über 1206 umkonfiguriert. Dabei werden Daten von außen (1204), also einer anderen Funktionseinheit oder außerhalb des Bausteins, in dem Funktionselement (1202) berechnet und dann über den Bus 1521 in den Schreibspeicher (1520) geschrieben.

Figur 15c zeigt den nächsten Schritt nach Figur 15b. Das Funktionselement (1202) und die Speicher (1203, 1530, 1531, 1532) wurden nach einem von dem Funktionselement oder den Speichern oder einer anderen Einheit generierten Trigger über 1206 umkonfiguriert. Der Schreibspeicher (1510,1520) ist jetzt als Lesespeicher (1531, 1532) konfiguriert. Die Lesespeicher liefern mehrere Operanden gleichzeitig an die Funktionselemente (1202). Dabei ist jeder Lesespeicher (1531, 1532) mit je einem unabhängigen Bussystem (1534, 1535) mit 1202 verbunden. Die Ergebnisse werden entweder über 1533 im Schreibspeicher (1530) gespeichert oder über 1205 weitergeleitet.

Beschrieben wird also ein Verfahren zur dynamischen Umkonfiguration von konfigurierbaren Bausteinen mit einer zwei- oder mehrdimensionalen Zellanordnung (z.B. FPGAs, DPGAs, DFPs o.e.), wobei
- 1.: eine oder mehrere Switching-Tabellen, bestehend aus einer oder mehreren Steuerungen und einem oder mehreren Konfigurationsspeichern auf dem Baustein existieren, oder an diesen angeschlossen werden,
- 2.: Konfigurationsworte von einer Switching-Tabelle an ein konfigurierbares Element oder mehrere konfigurierbare Elemente des Bausteins oder der Bausteine übertragen werden, welche eine gültige Konfiguration einstellen,
- 3.: die Ladelogik oder die konfigurierbaren Elemente des Bausteins oder der Bausteine , Daten in den oder die Konfigurationspeicher des oder der Switching-Tabelle schreiben können,
- 4.: die Steuerung des oder der Switching-Tabellen, einzelne Einträge als Befehle erkennen und diese Befehle ausführen kann,
- 5.: die Steuerung verschiedene Ereignisse erkennen und unterscheiden kann und daraufhin eine definierte Aktion durchführt,
- 6.: die Steuerung als Reaktion auf das Eintreffen eines Ereignisses oder einer Kombination von Ereignissen, den oder die Positionszeiger bewegt und, falls es sich um Konfigurationsdaten und nicht um Befehle für die Steuerung handelt, diese Konfigurationsdaten an die, in das oder die in den Konfigurationsdaten angegebenen konfigurierbaren Elemente schickt,
- 7.: die Steuerung eine oder mehrere Rückmeldungen an eine oder mehrere Ladelogiken senden kann,
- 8.: eine Ladelogik mehrere Ladelogiken dieses oder diese Signale erkennen und auswerten kann,
- 9.: eine Ladelogik Daten in die Konfigurationsspeicher des oder der Switching-Tabellen überträgt
oder
- 1.: einer Gruppe von konfigurierbaren Elementen (Funktionselement) ein Speicher zugeordnet ist, in dem die Ergebnisdaten zwischengespeichert werden,
- 2.: eine Switching-Tabelle oder Ladelogik ein Triggersignal erhält, sobald alle Ergebnisse berechnet sind,
- 3.: das Funktionselement daraufhin von einer SwitchingTabelle oder Ladelogik umkonfiguriert wird,
- 4.: der Speicher daraufhin von einer Switching-Tabelle oder Ladelogik umkonfiguriert wird,
- 5.: die Daten des Speichers in das Funktionselement geladen werden und neu verarbeitet werden,
- 6.: dabei auch die Daten neu von weiteren Funktionselementen hinzukommen können,
- 7.: dabei auch die Daten neu von weiteren Speichern hinzukommen können,
- 8.: das Ergebnis an weitere Funktionselemente, einen anderen oder denselben Speicher geführt werden kann,
- 9.: dieser Ablauf einmal oder mehrmals wiederholt wird.

Beschrieben wird weiter ein Verfahren nach der zweiten Alternative, wobei der Speicher als FIFO ausgestaltet sein kann und als Triggersignale das Full Flag verwendet wird und/oder wobei mehrere Speicherbänke existieren, die abwechselnd als Schreib- oder Lesespeicher arbeiten und/oder der Speicher ein Ringpuffer ist und/oder die Tiefe des Speichers konfigurierbar ist.

Beschrieben wurde weiter ein Verfahren nach der ersten Alternative des zusammengefasst formulierten Verfahrens, wobei eine Switching-Tabelle vorgesehen ist, die eine oder mehrere Lesepositionszeiger enthält und/oder eine Switching-Tabelle einen oder mehrere Schreibpositionszeiger enthält und/oder wobei der oder die Positionszeiger vorwärts, rückwärts oder auf einen beliebigen Eintrag innerhalb des Konfigurationsspeichers der Switching-Tabelle bewegt werden können und/oder nicht alle Einträge des Konfigurationsspeichers verwendet werden und/oder eine Rückmeldemöglichkeit der Tabellensteuerung an eine Ladelogik besteht.

## Patentansprüche

1. Programmierbarer Baustein mit
einer mindestens zweidimensionalen Zellanordnung konfigurierbarer Rechenwerke (0903) und
einer Konfigurationsdaten-Schickeinheit (0902), die als Quelle von Konfigurationsdaten dient und zumindest Teilen der Zellanordnung zugeordnet ist
**dadurch gekennzeichnet, dass**
als Einheit zur Kommunikation
zwischen
einzelnen konfigurierbaren Elementen (0905) und/oder Gruppen derselben
und
der Konfigurationsdaten-Schickeinheit (0902)
eine konfigurierbare Switching-Tabelle vorgesehen ist, aufweisend
einen Konfigurationsdaten-Speicher (0906)
zur Aufnahme besagter Konfigurationsdaten aus der Konfigurationsdaten-Schickeinheit,
der einzelnen konfigurierbaren Elementen und/oder Gruppen des programmierbaren Bausteins frei zugeordnet werden kann,
und
eine Steuerung (0907), die dazu ausgebildet ist,
einen Positionszeiger
als Reaktion auf das Eintreffen
eines von den Elementen des programmierbaren Bausteines gemeldeten Ereignisses oder einer Kombination solcher Ereignisse
auf eine Konfigurationsdaten-Speicherstelle zu bewegen,
um so zu ermöglichen, dass
konfigurationsabhängig
zur Laufzeit
ein Konfigurationswort aus dem Konfigurationsdaten-Speicher (0906) in das zu konfigurierende Element (0905) übertragen werden kann, um so eine Umkonfiguration durchzuführen.

2. Programmierbarer Baustein nach Anspruch 1,
**dadurch gekennzeichnet,**
**dass** das Rechenwerk als ALU realisiert ist.

3. Programmierbarer Baustein nach Anspruch 1 oder 2,
**dadurch gekennzeichnet,**
**dass** der Konfigurationsspeicher in Sektionen unterteilt oder unterteilbar ist, insbesondere in unabhängige Sektionen.

4. Programmierbarer Baustein nach dem vorhergehenden Anspruch, wobei jeweils die Einheit zur Kommunikation dazu ausgebildet ist, zur Laufzeit Konfigurationsdaten aus der Konfigurationsdaten-Schickeinheit zu empfangen.

5. Programmierbarer Baustein nach dem vorhergehenden Anspruch, wobei die Kommunikationseinheit dazu ausgebildet ist, in der Zeitspanne eines Verarbeitungszyklusses Konfigurationsdaten zu empfangen.

6. Programmierbarer Baustein nach einem der Ansprüche 3 bis 5, **dadurch gekennzeichnet,**
**dass** mehrere Steuerungen zum Zugriff auf eine Mehrzahl an Sektionen vorgesehen sind.

7. Programmierbarer Baustein nach dem vorhergehenden Anspruch, **dadurch gekennzeichnet,**
**dass** mehrere Schreib- und/oder mehrere Lesepositionszeiger unabhängig voneinander bewegbar vorgesehen sind.

8. Programmierbarer Baustein nach einem der vorhergehenden Ansprüche, **dadurch gekennzeichnet,**
**dass** die Steuerung dazu ausgebildet ist, zumindest einen Positionszeiger sprungartig zu bewegen.

9. Programmierbarer Baustein nach einem der vorhergehenden Ansprüche, **dadurch gekennzeichnet,**
**dass** der Konfigurationsdaten-Speicher als Ringspeicher, insbesondere als Ringspeicher mit mehreren Sektionen ausgebildet ist.

10. Programmierbarer Baustein nach dem vorhergehenden Anspruch, **dadurch gekennzeichnet,**
**dass** der Ringspeicher ausgebildet ist mit einer eigenen Adresssteuerung, die so ausgebildet ist, dass sie, wenn sie das Ende des Speichers erreicht hat, an dessen Anfang weiter läuft, und/oder die als Endlosspeicher in Form eines Ringes ausgebildet ist und/oder die in mehrere Sektionen aufgeteilt ist, wobei insbesondere nicht alle Einträge des Konfigurationsdatenspeichers verwendet werden.

11. Programmierbarer Baustein nach einem der vorhergehenden Ansprüche, worin die Steuerung dazu ausgebildet ist, den Positionszeiger bedingt aufgrund eines oder mehrerer Ereignisse auf den Beginn, das Ende oder eine angegebene Position sprungartig zu setzen, und wobei die Steuerung insbesondere ausgebildet ist, eine angegebene Anzahl an Einträgen des Ringspeichers zu überspringen.

12. Programmierbarer Baustein nach einem der vorhergehenden Ansprüche, **dadurch gekennzeichnet,**
**dass** die Konfigurationsdaten-Schickeinheit zur Entgegennahme eines Rückmeldungssignals ausgebildet ist.

13. Programmierbarer Baustein nach einem der vorhergehenden Ansprüche, **dadurch gekennzeichnet,**
**dass** die Steuerung dazu ausgebildet ist, eine Mehrzahl an Einträgen im Konfigurationsdatenspeicher innerhalb eines Systemtaktes abzuarbeiten.

14. Programmierbarer Baustein nach einem der vorhergehenden Ansprüche, worin die Steuerung dazu ausgebildet ist, auf eine Kombination von Ereignissen zumindest einen Lese- und/oder Schreibpositionszeiger auf eine Konfigurations-Speicherstelle zu bewegen, und wobei ein Ereignismaskenmittel vorgesehen ist, um die Ereigniskombination, auf welche reagiert werden soll, auszuwählen, insbesondere ein Ereignismaskenmittel, welches durch eine Verknüpfung von UND/ODER Gattern erhalten ist, insbesondere derartigen Gattern, bei welchen zumindest ein Eingang zur freien Programmierung derselben mit Leitungen verbunden ist, um ein Maskierungssignal (A) zu empfangen und so einen programmierbaren Produktsummegenerator vorzusehen.

15. Programmierbarer Baustein nach einem der vorhergehenden Ansprüche, worin die Steuerung dazu ausgebildet ist, Lese- und/oder Schreibpositionszeiger als Reaktion auf das Eintreffen zumindest eines Ereignisses auf eine Konfigurationsspeicherstelle zu bewegen, wobei das Ereignis ausgewählt ist aus Takt, internem oder externem Interruptsignal, Triggersignal von anderen Elementen innerhalb des Bausteines, Vergleich eines Datenstromes und/oder eines Befehlstromes mit einem Wert, Input/Output-Ereignis, Ablaufen, Überlaufen, Neusetzen eines Zählers und/oder Auswerten eines Vergleiches.

16. Programmierbarer Baustein nach einem der vorhergehenden Ansprüche, **dadurch gekennzeichnet,**
**dass** ein Speicher zum Abspeichern von Daten vor und/oder nach einem Schritt der Verarbeitung von Daten in dem Feld von Elementen vorgesehen ist.

17. Verfahren zum Betrieb eines programmierbaren Bausteins nach einem der vorhergehenden Ansprüche mit einem Feld von konfigurierbaren Elementen und Eingangs- und Ausgangsbussen daran zum Zuführen von Daten und Ausgeben von Daten, die das Feld ein- oder mehrfach durchlaufen haben,
**dadurch gekennzeichnet,**
**dass** Daten vor und/oder nach einem Schritt der Verarbeitung von Daten in dem Feld abgespeichert werden.

18. Verfahren nach dem vorhergehenden Anspruch, wobei weiter bei einzelnen konfigurierbaren Elementen oder Gruppen derer zumindest ein Konfigurationsdaten-Speicher zur Aufnahme von Konfigurationsdaten aus einer Konfigurationsdaten-Schickeinheit zugeordnet ist, wobei die Daten in dem Feld verarbeitet werden, in dem Speicher abgespeichert werden, eine Umkonfiguration im Rückgriff auf Konfigurationsdaten aus dem Konfigurationsdaten-Speicher der zugeordneten konfigurierbaren Elemente oder Gruppen derer erfolgt und die gespeicherten Daten in das Feld eingespeist werden, um neuerlich bearbeitet zu werden.

## Claims

1. Programmable module comprising
an at least two-dimensional cell arrangement of configurable arithmetic units (0903) and
a configuration data sending unit (0902), which serves as a source of configuration data and is assigned to at least parts of the cell arrangement,
**characterized in that**
as a unit for communication
between
individual configurable elements (0905) and/or groups thereof
and
the configuration data sending unit (0902),
a configurable switching table is provided,
having
a configuration data memory (0906)
for receiving said configuration data from the configuration data sending unit,
which memory can be freely assigned to individual configurable elements and/or groups of the programmable module,
and
a controller (0907) designed to move a position pointer
as a reaction to the arrival of an event reported by the elements of the programmable module, or a combination of such events,
to a configuration data memory location,
in order thus to make it possible that
in a configuration-dependent manner,
in relation to the run time,
a configuration word can be transferred from the configuration data memory (0906) to the element (0905) to be configured, in order thus to carry out a reconfiguration.

2. Programmable module according to Claim 1,
**characterized**
**in that** the arithmetic unit is realized as an ALU.

3. Programmable module according to Claim 1 or 2,
**characterized**
**in that** the configuration memory is subdivided or can be subdivided into sections, in particular into independent sections.

4. Programmable module according to the preceding claim,
wherein the unit for communication is in each case designed to receive configuration data from the configuration data sending unit in relation to the run time.

5. Programmable module according to the preceding claim,
wherein the communication unit is designed to receive configuration data in the time period of a processing cycle.

6. Programmable module according to any of Claims 3 to 5,
**characterized**
**in that** provision is made of a plurality of controllers for accessing a plurality of sections.

7. Programmable module according to the preceding claim,
**characterized**
**in that** a plurality of write and/or a plurality of read position pointers are provided such that they are movable independently of one another.

8. Programmable module according to any of the preceding claims,
**characterized**
**in that** the controller is designed to move at least one position pointer abruptly.

9. Programmable module according to any of the preceding claims,
**characterized**
**in that** the configuration data memory is embodied as a ring memory, in particular as a ring memory having a plurality of sections.

10. Programmable module according to the preceding claim,
**characterized**
**in that** the ring memory is embodied with a dedicated address controller which is designed such that, if it has reached the end of the memory, it continues to the start of said memory, and/or which is designed as a continuous memory in the form of a ring and/or which is divided into a plurality of sections, wherein, in particular, not all the entries of the configuration data memory are used.

11. Programmable module according to any of the preceding claims,
wherein the controller is designed to abruptly set the position pointer to the beginning, the end or a specified position conditionally on account of one or more events, and wherein the controller is designed, in particular, to skip a specified number of entries of the ring memory.

12. Programmable module according to any of the preceding claims,
**characterized**
**in that** the configuration data sending unit is designed to receive a feedback signal.

13. Programmable module according to any of the preceding claims,
**characterized**
**in that** the controller is designed to process a plurality of entries in the configuration data memory within a system clock cycle.

14. Programmable module according to any of the preceding claims,
wherein the controller is designed to move at least one read and/or write position pointer to a configuration memory location in response to a combination of events, and wherein an event mask means is provided in order to select the event combination to which a reaction is intended to be effected, in particular an event mask means which is obtained by a combination of AND/OR gates, in particular such gates in which at least one input for the free programming of said gates is connected to lines in order to receive a masking signal (A) and thus to provide a programmable product sum generator.

15. Programmable module according to any of the preceding claims,
wherein the controller is designed to move read and/or write position pointers to a configuration memory location as a reaction to the arrival of at least one event, wherein the event is selected from clock signal, internal or external interrupt signal, trigger signal of other elements within the module, comparison of a data stream and/or a command stream with a value, input/output event, progression, overflow, resetting of a counter and/or evaluation of a comparison.

16. Programmable module according to any of the preceding claims,
**characterized**
**in that** provision is made of a memory for storing data before and/or after a step of processing data in the array of elements.

17. Method for operating a Programmable module according to any of the preceding claims with an array of configurable elements and input and output buses thereon for feeding data and outputting data which have passed through the array once or multiply,
**characterized**
**in that** data are stored before and/or after a step of processing data in the array.

18. Method according to the preceding claim, wherein furthermore in the case of individual configurable elements or groups thereof, at least one configuration data memory is assigned for receiving configuration data from a configuration data sending unit, wherein the data are processed in the array and are stored in the memory, a reconfiguration is effected with recourse to configuration data from the configuration data memory of the assigned configurable elements or groups thereof and the stored data are fed into the array in order to be processed again.

## Revendications

1. Module programmable comprenant :
un agencement au moins bidimensionnel d'unités de calcul configurables (0903) et
une unité (0902) d'envoi de données de configuration qui est utilisée comme source de données de configuration et est affectée à au moins une partie de l'agencement de cellules,
**caractérisé en ce que**,
entre des éléments configurables individuels (0905) et/ou groupes de ceux-ci, et
l'unité d'envoi de données de configuration (0902), se trouve une unité de commutation configurable comprenant :
une mémoire de données de configuration (0906) destinée à l'enregistrement desdites données de configuration en provenance de l'unité d'envoi de données de configuration,
qui peut être librement affectée à des éléments configurables individuels du module programmable et/ou groupes de ceux-ci,
et
une unité de commande (0907) qui est conçue pour déplacer un pointeur de position vers un emplacement de mémoire de données de configuration en réaction à la survenue
d'un événement signalé par les éléments du module programmable ou d'une combinaison de tels événements, afin de faire en sorte que
un mot de configuration puisse être transféré de la mémoire de données de configuration (0906) à l'élément (0905) à configurer d'une manière qui dépend de la configuration et pendant le temps d'exécution, afin d'effectuer ainsi une reconfiguration.

2. Module programmable selon la revendication 1, **caractérisé en ce que** l'unité de calcul est réalisée sous la forme d'une ALU (Arithmetic Logic Unit pour Unité Arithmétique et Logique).

3. Module programmable selon la revendication 1 ou 2, **caractérisé en ce que**
la mémoire de configuration peut être subdivisée en sections, notamment en sections indépendantes.

4. Module programmable selon la revendication précédente, dans lequel chaque unité est conçue à des fins de communication de manière à recevoir de l'unité d'envoi de données de configuration des données de configuration pendant le temps d'exécution.

5. Module programmable selon la revendication précédente, dans lequel l'unité de communication est conçue de façon à recevoir des données de configuration pendant la durée d'un cycle de traitement.

6. Module programmable selon l'une des revendications 3 à 5, **caractérisé en ce qu'**il est prévu plusieurs unités de commande pour accéder à une pluralité de sections.

7. Module programmable selon la revendication précédente, **caractérisé en ce qu'**il est prévu plusieurs pointeurs de position d'écriture et/ou plusieurs pointeurs de position de lecture pouvant être déplacés indépendamment les uns des autres.

8. Module programmable selon l'une des revendications précédentes, **caractérisé en ce que** l'unité de commande est conçue de manière à déplacer par sauts au moins un pointeur de position.

9. Module programmable selon l'une des revendications précédentes, **caractérisé en ce que** la mémoire de données de configuration est réalisée sous la forme d'une mémoire annulaire, notamment d'une mémoire annulaire à plusieurs sections.

10. Module programmable selon la revendication précédente, **caractérisé en ce que** la mémoire annulaire est réalisée de manière à comporter sa propre unité de commande d'adressage, qui est conçue de telle manière que lorsqu'elle a atteint la fin de la mémoire, elle retourne au début de celle-ci, et/ou qui est conçue en tant que mémoire sans fin sous la forme d'un anneau et/ou qui est divisée en plusieurs sections, dans lequel, notamment, les entrées de la mémoire de données de configuration ne sont pas toutes utilisées.

11. Module programmable selon l'une des revendications précédentes, dans lequel l'unité de commande est conçue de manière à positionner par sauts le pointeur de position en fonction d'un ou de plusieurs événements au début, à la fin ou à une position donnée, et dans lequel l'unité de commande est notamment conçue de manière à sauter un nombre donné d'entrées de la mémoire annulaire.

12. Module programmable selon l'une des revendications précédentes, **caractérisé en ce que** l'unité d'envoi de données de configuration est conçue pour recevoir un signal de rétroaction.

13. Module programmable selon l'une des revendications précédentes, **caractérisé en ce que** l'unité de commande est conçue pour traiter une pluralité d'entrées dans la mémoire de données de configuration en moins d'un cycle d'horloge du système.

14. Module programmable selon l'une des revendications précédentes, dans lequel la commande est conçue pour déplacer au moins un pointeur de position de lecture et/ou d'écriture vers un emplacement de mémoire de configuration lors d'une combinaison d'événements, et dans lequel il est prévu un moyen de masquage d'événements permettant de sélectionner la combinaison d'événements à laquelle une réaction doit être fournie, notamment un moyen de masquage d'événements qui est obtenu par une combinaison de portes ET/OU, notamment de portes dont au moins une entrée est reliée à un conducteur destiné à une libre programmation de celle-ci afin qu'elle puisse recevoir un signal de masquage (A) et ainsi constituer un générateur de somme de produits programmable.

15. Module programmable selon l'une des revendications précédentes, dans lequel la commande est conçue de manière à déplacer des pointeurs de lecture et/ou d'écriture en réaction à la survenue d'au moins un événement vers un emplacement de la mémoire de configuration, dans lequel l'événement est choisi parmi une impulsion d'horloge, un signal d'interruption interne ou externe, un signal de déclenchement d'autres éléments internes au module, une comparaison d'un flux de données et/ou d'un flux d'erreurs à une valeur, un événement d'entrée/sortie, la progression, le dépassement, la réinitialisation d'un compteur et/ou l'évaluation d'une comparaison.

16. Module programmable selon l'une des revendications précédentes, **caractérisé en ce qu'**il est prévu une mémoire destinée à mémoriser des données avant et/ou après une étape du traitement de données dans la matrice d'éléments.

17. Procédé d'utilisation d'un module programmable selon l'une des revendications précédentes, comprenant une matrice d'éléments configurables et de bus d'entrée et de sortie destinés à y introduire des données et à en extraire des données qui sont passées une fois ou plusieurs fois à travers la matrice, **caractérisé en ce que** des données sont mémorisées dans la matrice avant et/ou après une étape du traitement de données.

18. Procédé selon la revendication précédente, dans lequel au moins une mémoire de données de configuration destinée à enregistrer des données de configuration provenant d'une unité d'envoi de données de configuration est en outre affectée à des éléments configurables individuels ou à des groupes de ceux-ci, dans lequel les données sont traitées dans ladite matrice et sont mémorisées dans la mémoire, une reconfiguration est effectuée par recours à des données de configuration provenant de la mémoire de données de configuration des éléments configurables associés ou groupes de ceux-ci, et les données mémorisées sont fournies à ladite matrice afin qu'elles soient à nouveau traitées.
